# FASCICULE DE BREVET EUROPEEN

(11) **EP 0 892 985 B1**
(45) Date de publication et mention de la délivrance du brevet: **10.07.2002**
(21) Numéro de dépôt: 97919462.8
(22) Date de dépôt: 02.04.1997
(51) Int. Cl.: H01L 21/00

(54) **DISPOSITIF DE TRANSPORT D'OBJETS PLATS ET PROCEDE DE TRANSFERT DE CES OBJETS ENTRE LEDIT DISPOSITIF ET UNE MACHINE DE TRAITEMENT**
TRANSPORTEINRICHTUNG FÜR FLACHE GEGENSTÄNDE UND VERFAHREN ZUM TRANSFERIEREN DIESER GEGENSTÄNDE ZWISCHEN DIESER EINRICHTUNG UND EINEM BEHANDLUNGSAPPARAT
TRANSPORT DEVICE FOR FLAT OBJECTS AND PROCESS OF TRANSFER OF THESE OBJECTS BETWEEN THE DEVICE AND A TREATMENT APPARATUS

(30) Priorité: 03.04.1996 FR 9604173
(43) Date de publication de la demande: 27.01.1999
(73) Titulaire: COMMISSARIAT A L'ENERGIE ATOMIQUE, 75015 Paris (FR)
(72) Inventeur: DOCHE, Claude, F-38640 Claix (FR)
(74) Mandataire: Dubois-Chabert, Guy
(86) Numéro de dépôt international: FR9700587
(87) Numéro de publication internationale: WO9738439

(56) Documents cités:
- EP-A- 0 582 018
- EP-A- 0 591 085
- EP-A- 0 593 366
- WO-A-92/02950

## Description

### Domaine technique

L'invention concerne un dispositif de transport d'objets plats, dénommés cassettes ou paniers, et un procédé de transfert de ces objets entre ledit dispositif et une machine de traitement garantissant un environnement particulier autour de l'objet, sans aucune discontinuité des spécification de cet environnement même au moment du transfert de l'objet dans la machine de procédé.

### Etat de la technique antérieure

L'invention se rapporte au domaine de la fabrication d'objets plats en milieu ultrapropre. Une telle fabrication utilise conventionnellement la technologie de la salle blanche qui consiste à traiter globalement l'atmosphère dans laquelle ces objets sont fabriqués, manipulés, stockés. Dans les industries agroalimentaire, pharmaceutique et microélectronique, notamment, de nombreux objets sont ainsi fabriqués en atmosphère de salle blanche afin d'éviter les risques de contamination.

Dans l'industrie microélectronique, la contamination est particulièrement redoutée dans la fabrication de pièces nécessitant de réaliser des gravures très fines et des couches de très faibles épaisseurs, telles que les écrans plats (LCD), et surtout dans la fabrication de dispositifs semiconducteurs, tels que les microprocesseurs ou les mémoires statiques ou dynamique, etc... où la densité d'intégration est très élevée.

Pour simplifier la description, dans la suite, on considérera à titre d'exemple cette industrie microélectronique, et plus particulièrement le cas du traitement de plaques de semi-conducteur, par exemple de silicium. La fabrication des circuits électroniques sur des plaques de semi-conducteur ("wafers"), par exemple circulaires, nécessite, en effet, que ces dernières soient traitées, manipulées, stockées sous atmosphère ultrapropre, c'est-à-dire entourées d'un gaz d'ultra propreté et/ou ultrapur comme de l'air très propre ou de l'azote.

Il existe principalement deux sortes de contaminations, à savoir la contamination d'origine particulaire et la contamination d'origine physico-chimique, ou contamination moléculaire.

La contamination d'origine particulaire est due à un dépôt physique de particules sur le produit fabriqué, susceptible d'engendrer des phénomènes physiques. Dans le domaine microélectronique sur les plaques de semi-conducteur, de telles particules peuvent entraîner des courts-circuits ou des coupures de connexion électrique, entraînant des chutes de rendement.

La contamination d'origine physico-chimique ou moléculaire vient principalement de l'air de la salle blanche, riche particulièrement en composants carbonés volatils.

Ces contaminants passent à travers le système de filtration. De plus ils sont souvent générés aussi dans la salle blanche, par les filtres, les joints de filtres, les surfaces plastiques et aussi à proximité des plaques de silicium (paniers et boîtes de transport en plastique).

Même si la relation présence de contaminants moléculaires-perte de rendement est encore difficile à démontrer, on sait que chimiquement ces espèces peuvent être absorbées à la surface de la plaque de silicium. Les nouvelles liaisons chimiques vont être révélées par les traitements thermiques pour devenir de réels défauts impactant les rendements. Ces. contaminants peuvent venir des procédés eux-mêmes et sont véhiculés par la plaque de silicium elle-même, qui contaminera toutes les surfaces qui seront à proximité de la plaque.

Pour éviter la contamination particulaire on peut, à présent, utiliser différentes solutions.

Un première solution consiste à mettre le local, où sont manipulées ces plaques de semi-conducteur, sous une atmosphère ultrapropre, c'est-à-dire sous atmosphère contrôlée.

Le contrôle de l'environnement de l'objet consiste alors à le protéger de toutes les sources de contamination provenant essentiellement des opérateurs et des machines de fabrication. Cette protection est réalisée en créant un flux d'air dans la salle, le plus laminaire possible, créant des veines de protection autour des objets et entraînant toutes les particules vers les bouches de reprise, en général placées dans le faux plancher.

Cette solution est la plus couramment utilisée. Elle permet d'atteindre des classes d'empoussièrement de classe 1 signifiant qu'il n'existe pas plus de une particule de taille supérieure à 0,5 µm dans un pied cube (1 pied = 0,3048 m ; norme 209 Federal Standard, "Airborne Particulate Cleanliness Classes in Clean Rooms and Clean Zones"). Avec ce mode de protection il est envisagé d'atteindre des classes meilleures que 1. Etant donné que l'on se trouve quasiment à la limite du réalisable au niveau de filtres, la seule façon d'atteindre une meilleure propreté est d'augmenter le nombre de renouvellements d'air dans la salle.

On voit que l'on atteint les limites de la technologie "salle blanche" et que les améliorations, s'il est encore possible d'en avoir, ne se feront qu'au prix d'une augmentation importante des coûts de fonctionnement entraînée par les quantités d'énergie nécessaires pour assurer le recyclage de l'air.

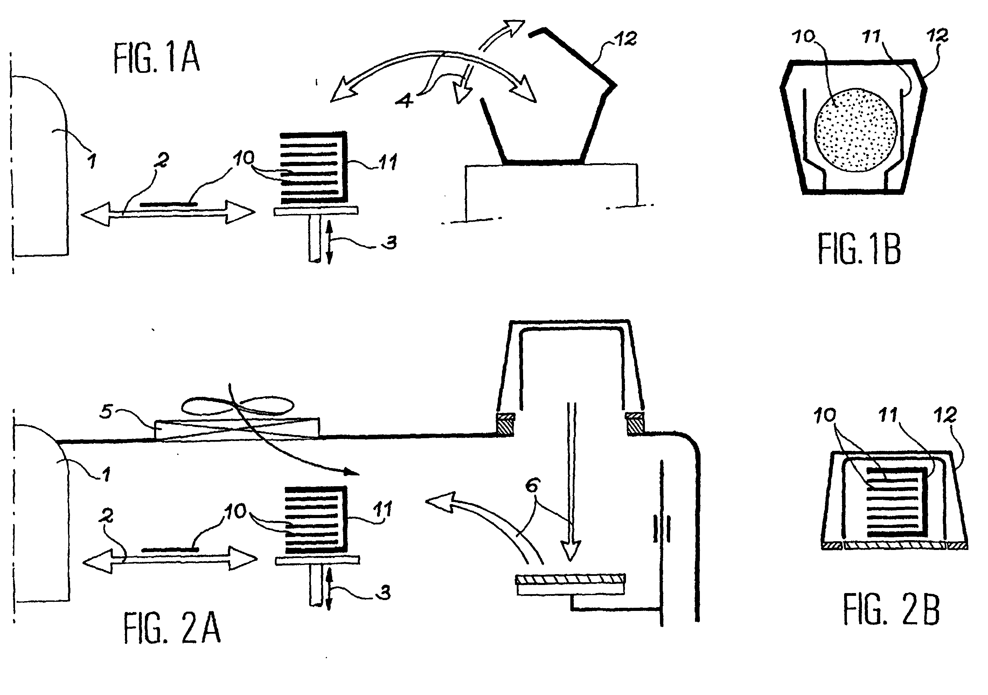

Dans cette solution les plaques de silicium 10 sont rangées dans des paniers 11 contenant vingt cinq plaques. Comme le montre la figure 1 ces paniers 11 sont chargés manuellement sur les ports d'entrée-sortie des équipements de fabrication, cette opération étant particulièrement contaminante.

Pour les transports dans l'unité de production ou de stockage, les paniers sont rangés et protégés par une boîte de transport 12.

Sur la figure 1A sont représentées les zones de travail et équipements, et les ports d'entrée des équipements "passe paroi". Sur cette figure sont représentés un réacteur 1, un robot 2, un ascenseur 3, les opérations 4 étant des opérations manuelles. Sur la figure 1B sont représentées les zones de circulation et de stockage.

Une seconde solution consiste à réduire les volumes "ultrapropres" aux seuls endroits où sont manipulés les plaques de silicium. Il s'agit donc principalement des postes de travail. On réalise alors, autour de ces zones sensibles, des mini-environnements ("Enclosure on Canopy") dans lesquels on installe un système de filtration très efficace 5, comme représenté sur la figure 2. De même que pour les figures 1A et 1B, la figure 2A correspond aux zones de travail et la figure 2B au transfert et au stockage.

Dans ce cas les paniers 11 de plaques 10 sont placés dans des boîtes 12 (ou "Pod") "quasiment" étanches. Ces boîtes sont ouvertes automatiquement (6) dans l'environnement ultrapropre du mini-environnement, afin de pouvoir transférer le panier 11 ou les plaques 10 dans de très bonnes conditions de propreté. Essentiellement utilisée dans le domaine de la microélectronique, cette technologie dénommée SMIF ("Standard Mechanical Interface") conduit à des réductions significatives des coûts de fonctionnement. Cette approche permet sans doute une légère amélioration de la classe d'empoussièrement, mais elle se heurte aux mêmes limites que celles de la salle blanche conventionnelle.

De plus, ces améliorations sont obtenues au détriment d'un interfaçage avec les machines plus complexe nécessitant souvent des éléments robotiques coûteux.

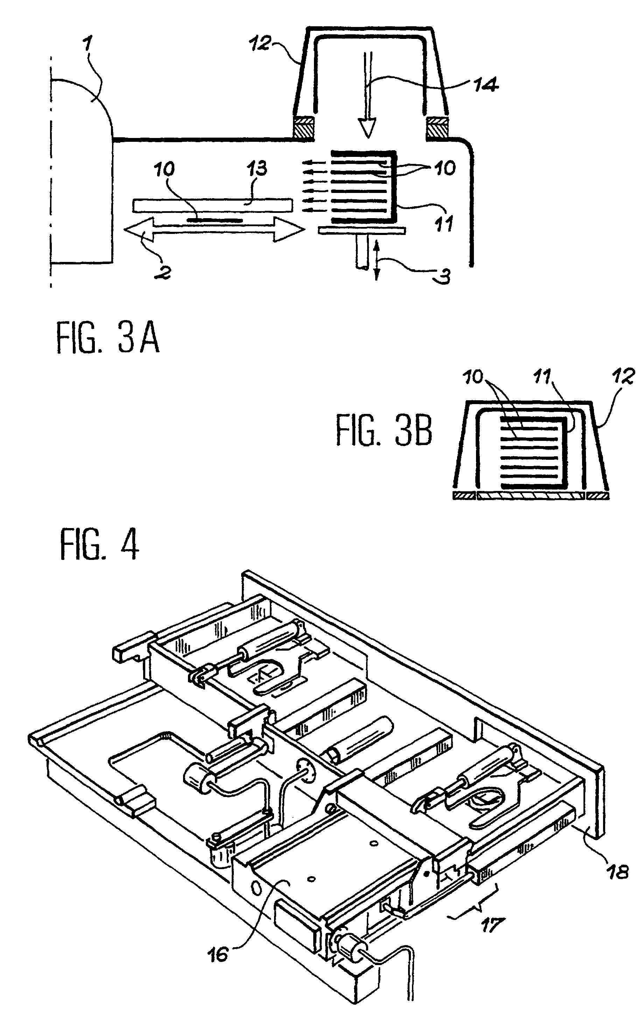

Pour atteindre des classes de propreté inférieures à 1, la technologie dite "WAFEC", illustrée sur la figure 3, propose de créer localement autour du panier 11 une mini-salle blanche mobile. Cette technologie est conçue pour pouvoir déposer les paniers de plaques sur les entrées des machines sans dispositif supplémentaire, en garantissant les conditions de propreté par un flux d'air ultrapropre permanent autour des plaques. De plus un flux d'air localisé accompagne la plaque dans une veine d'air ultrapropre jusqu'à l'entrée des réacteurs des machines. La figure 3A correspond aux zones de travail, et la figure 3B aux zones de transfert-stockage. Dans cette technologie il y a protection dynamique de l'enceinte, protection rapprochée des "wafers" 13 et transfert automatique de la cassette 14.

Cette technologie a permis d'atteindre des classes meilleures que 0,01. Bien que prometteuse, elle n'a pas connu le succès industriel espéré par le fait que la génération permanente d'air ultrapropre nécessite des générateurs d'air mobiles pour accompagner les containers, dispositifs pas accepté dans un environnement de production.

Ces trois solutions sont sans doute en mesure de régler le problème de la contamination particulaire, mais aucune d'entre elles ne permet de garantir un environnement exempt de contaminants moléculaires, constamment présents dans l'air des salles blanches, générés par tous les composants plastiques, les filtres, les joints des filtres, le matériau des paniers et des boites de transport.

De plus ces trois solutions manipulent des paniers conventionnels contenant en général vingt cinq plaques et donc aucune ne permet de réaliser la flexibilité dont l'industrie microélectronique a besoin pour optimiser le temps d'attente sur les machines en vue de réduire le temps de cycle.

Pour envisager d'apporter une solution au besoin de pureté (environnement exempt de contaminants moléculaires), la technologie SMIF a proposé d'introduire de l'azote dans la boîte 12 ou "Pod" au moment où la boîte est en attente (ou stockage).

Une autre approche proposée ("Portable Clean Room") propose une technologie de transport des paniers entre les différentes machines dans des containers maintenus sous azote par une bouteille d'azote embarquée. Cette technologie présente les mêmes inconvénients que la technologie SMIF pour transférer les objets dans les équipements ou machines de procédé.

Une autre solution est celle des containers individuels qui a le double objectif d'une part de créer un environnement ultrapropre et ultrapur autour des plaques de silicium et d'autre part, de permettre une grande flexibilité. Une telle solution consiste à confiner les plaques dans des containers individuels. Différentes variantes de cette solution existent : l'une proposée par IMB (références [1] et [2] en fin de description et illustrée sur la figure 4) et l'autre proposée par le Commissariat à l'Energie Atomique (LETI) (références [3], [4] et [5]).

Sur la figure 4 on retrouve notamment un container individuel IBM 16, la zone d'ouverture du container 17, et le module 18 d'interfaçage des équipement selon IBM.

Même si ces deux solutions techniques sont différentes, elles présentent déjà beaucoup d'avantages par rapport aux solutions de mini-environnement de type SMIF en matière de protection des plaques de silicium contre les contaminants particulaires et moléculaires résultant d'une meilleure étanchéité et de capacités de renouveler l'environnement.

Par contre une telle approche présente encore plusieurs inconvénients, notamment :
- la nécessité de disposer d'un module spécifique entre le container et l'équipement pour réaliser le transfert des plaques de silicium ;
- la non-continuité de la chaîne de protection des protections au niveau des zones d'ouverture due à la difficulté de réaliser une étanchéité parfaite entre le container et le module d'interface compte tenu des systèmes d'ouverture de ce type de container individuel ;
- l'interfaçage individuel des machines, bien que théoriquement optimal en terme de flexibilité, se trouve être sous-optimal pour les applications en microélectronique compte tenu du fait que la majorité des équipements de traitement demandent, pour être utilisés de façon optimale, que plusieurs plaques soient disponibles en même temps à l'entrée de la machine. De plus, le transport individuel impose une augmentation importante du nombre de transactions d'informations pour garantir le suivi parfait des objets fabriqués.

En outre, dans ces dispositifs de l'art antérieur décrivant des mini-environnements individuels, les portes sont solidaires des dispositifs d'ouverture et de fermeture et cela nuit à l'étanchéité "mécanique" lors de l'accouplement avec la machine.

De plus les amenées de gaz sont situées sur les côtés. Pour les alimenter en gaz de façon collective, il est nécessaire de les empiler sur une étagère munie de canaux de distribution de gaz permettant d'alimenter chaque alvéole.

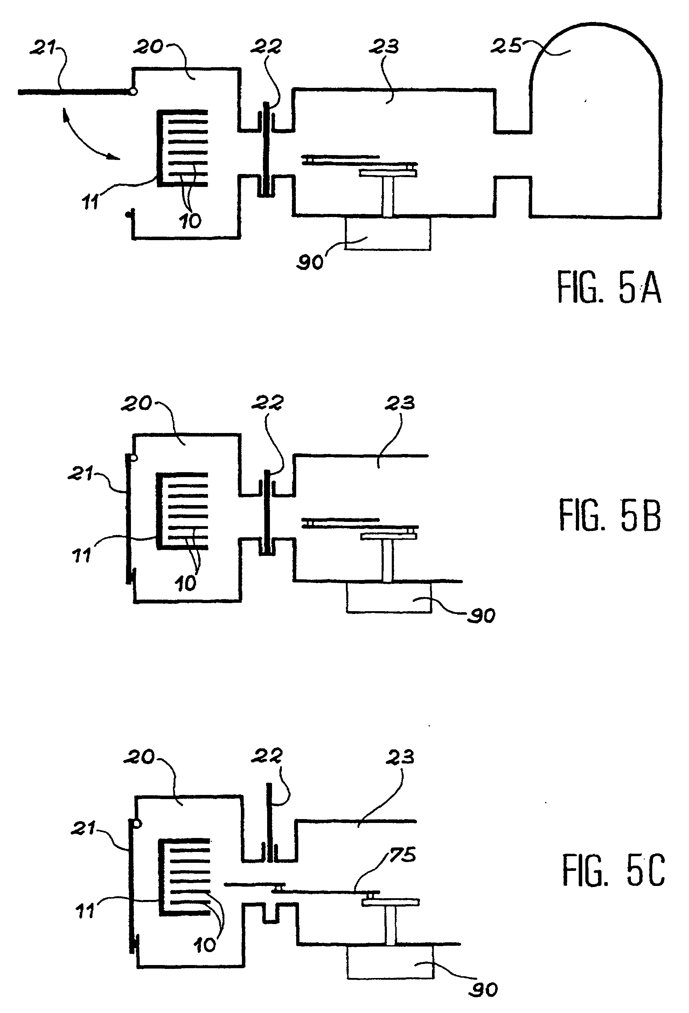

Toutes les solutions existantes de mini-environnement collectif (comme SMIF), ou individuel (comme les solutions IBM ou CEA) nécessitent des adaptations particulières des machines de traitement, ou des modules de transfert spécifiques pour transférer les paniers et/ou les plaques vers les machines de traitement. Cet inconvénient majeur par rapport au fonctionnement conventionnel, qui consiste à charger directement le panier sur l'ascenseur de la machine, est amplifié dans le cas des équipements réalisant un procédé de fabrication dans le vide. Ces équipements, en effet, présentent un sas d'entrée dans lequel est introduit le panier, puis ce sas est fermé et amené au niveau de vide du coeur de la machine pour pouvoir alors mettre en communication physique entre celui-ci et le coeur de la machine afin de pouvoir réaliser les transferts d'objets, comme illustré sur la figure 5.

Sur la figure 5A on a une première étape d'ouverture du sas 20, et d'introduction du panier 11. Sur cette figure sont représentés la porte du sas 21, une vanne 22, un module de transfert vide 23, un robot de transfert 90 et la chambre de traitement 25.

Sur la figure 5B on a une seconde étape de fermeture du sas 20, et de descente en vide du sas.

Sur la figure 5C on a une troisième étape de transfert, la vanne 22 étant ouverte permettant au robot 90 du module de transfert d'échanger des plaques 10 entre le panier 11 dans le sas 20 et la chambre de traitement 25.

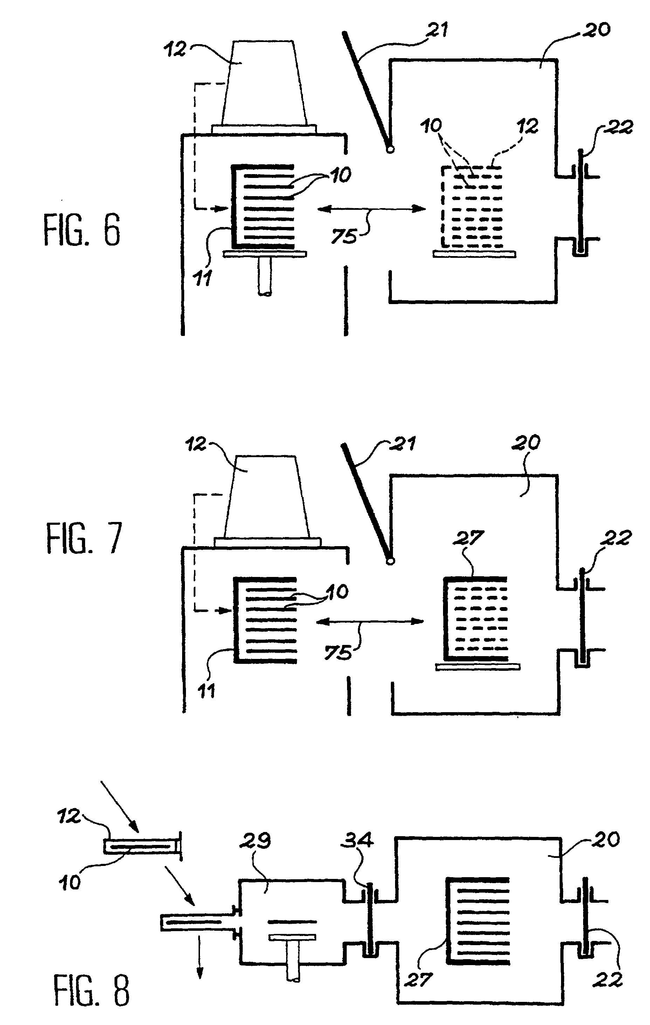

Dans le cas des solutions de type mini-environnement collectif, il existe deux solutions pour transférer les objets plats. La première solution, illustrée sur la figure 6, consiste, après avoir ouvert le container 12 ou "Pod", à transférer grâce à un bras robotisé 75 le panier 11 à l'intérieur du sas. Une deuxième solution, illustrée sur la figure 7, consiste à transférer les plaques de silicium 10 du panier 11 appartenant au container à un autre panier 27 installé à demeure dans le sas 20. Dans ce cas un robot multidoigt 90, souvent intégré au sas, est capable de réaliser ce transfert.

Dans le cas des mini-environnements individuels, comme illustré sur la figure 8, le robot d'un module d'interface 29 décrit précédemment assure le transfert séquentiel de la plaque dans un panier installé à demeure dans le sas 20. Les containers individuels sont connectés séquentiellement au module d'interface pour transférer le nombre de plaques prévus dans le panier 27 du sas. Une vanne supplémentaire 34 permet d'isoler le sas du module d'interface, elle joue le même rôle que la porte du sas.

Ainsi différents dispositifs de l'art antérieur permettent d'effectuer le transport de telles plaques de semi-conducteur :
- Les premiers sont des dispositifs conventionnels ou paniers standard, comme illustré sur la figure 1, dans lesquels les plaques sont rangées. Ces paniers peuvent être transportés dans des boîtes de transport. La protection contre la contamination est réalisée par le flux d'air ultrapropre de la salle blanche, surtout au moment des transferts du panier de la boîte de transport sur la machine.
- Les seconds sont des mini-environnements de type collectif de type SMIF qui permettent le transport de plusieurs plaques de semi-conducteur à la fois. Ce sont des dispositifs statiques qui garderont la mémoire de l'environnement dans lequel ils sont ouverts. Un tel mini-environnement est moyennement étanche, une purge de celui-ci pouvant d'ailleurs être prévue. Il nécessite un interface spécifique avec les équipements sous vide, par exemple pour réaliser un transfert de panier, et un transfert des plaques, comme illustré sur la figure 2. Une variante a été introduite pour protéger au plus près la plaque et recréer en permanence le propreté autour de la plaque, comme illustré sur la figure 3.
- Les derniers sont des mini-environnements de type monoplaque, comme décrits notamment dans les références données en fin de description. Ces mini-environnements, qui sont des dispositifs actifs, de l'azote étant contenu dans ceux-ci, nécessitent un grand nombre de transferts. Même si les équipements fonctionnent une plaque après l'autre ("Single Wafer Processing"), tous ont des tampons d'entrée imposant un nombre minimum de plaques.

Aujourd'hui on protège les plaques de semi-conducteur contre les contaminants particulaires. Mais il est impératif, pour garantir les rendements de production, de protéger ces plaques contre les contaminants moléculaires, dont les V.O.C. ("Volatil Organic Contaminants").

Ces contaminants V.O.C. ont des origines diverses :
- composants contenus dans l'air extérieur avant filtration ;
- dégazage de tous les composants plastiques utilisés dans la réalisation de salles blanches, filtres, joints de filtre, panneaux plastiques... ;
- panier et boîte de transport des plaques ;
- plaques de semi-conducteur après certains procédés qui libèrent des amines, des acétones....
l'existence de tels contaminants a plusieurs conséquences désavantageuses :
- existence de pertes de rendement ; ou
- nécessité d'étapes de procédé supplémentaires pour traiter les surfaces des plaques de semi-conducteur avant certains procédés critiques.

Le maintien d'un environnement "inerte" autour des plaques de semi-conducteur s'avère nécessaire pour s'affranchir de ce type de contamination. L'azote est un exemple de gaz recommandé. Un tel choix permet aussi d'avoir un environnement exempt d'oxygène (pas de croissance d'oxyde natif) et de vapeur d'eau (pas de corrosion des métaux) utilisés pour réaliser les niveaux d'interconnexion.

Un premier document de l'art antérieur,la demande de brevet WO-A-92 02950, décrit un dispositif de stockage, de transport et de protection de substrats, dans les conditions de chambre propre. Les substrats sont emmagasinés séparément dans des cassettes qui peuvent être étroitement emboîtées les unes sur les autres. Les cassettes sont positionnées, grâce à un monte-charge, devant une fente de chargement dans la chambre propre. Un ocuvercle hermétique latéral sur la cassette est ouvert et le substrat est saisi et, après passage à travers ladite fente, déposé sur un support.

Un second document de l'art antérieur, la demande de brevet EP-A-0 591 085, décrit un système à purge de gaz pour une enceinte d'isolation pour des éléments sensibles à la contamination. Cette enceinte comporte une coquille et un élément de fermeture adapté pour purger des gaz de l'enceinte. L'élément de fermeture comporte des filtres et des vidanges de vapeur et d'humidité.

Différents problèmes se posent aujourd'hui à l'homme de l'art :
- Celui de garantir autour des objets plats, par exemple des plaques de semi-conducteur, sans aucune discontinuité, un environnement ultrapropre, mais aussi ultrapur nécessitant de réaliser une véritable chaîne continue de pureté. L'environnement des plaques de semi-conducteur sera toujours inerte de manière à maintenir la plaque dans un environnement exempt de contaminants moléculaires dont les contaminants chimiques volatils, dont les V.O.C. (ou "Volatil Organic Contaminants") sont une espèce particulièrement génératrice de défectivité.
- Celui de réduire le temps de cycle et donc du nombre de plaques immobilisées, qui sera résolu en introduisant de la flexibilité dans la taille des lots pour optimiser le temps d'attente sur les machines, sans aller jusqu'à la flexibilité extrême du transport individuel qui n'est optimale que pour un nombre limité de machines, et qui augmente considérablement le nombre de transactions d'information.
- Celui de pouvoir interfacer les équipements de traitement sans module intermédiaire et en particulier de pouvoir rentrer dans le sas vide des équipements, comme les paniers conventionnels.

L'invention a pour objet de résoudre les deux problèmes (isolation des plaques dans un environnement adapté, de préférence azoté et possibilité de flexibilité) et de proposer un dispositif dont l'utilisation reste très proche d'un fonctionnement conventionnel avec des paniers de transport standards, de façon à conserver le même type d'interface avec les équipements de traitement, même pour ce qui est des équipements réalisant le traitement dans le vide.

### Exposé de l'invention

La présente invention concerne un dispositif collectif de transport d'objets plats confinés individuellement dans une atmosphère déterminée comportant un empilement de plusieurs modules de forme plate chaque module comprenant une alvéole plate de faible épaisseur débouchant sur une face latérale dudit module, chaque module étant apte à recevoir un seul objet plat et à être fermé par une porte indépendante, caractérisé en ce que chaque module comprend au moins trois plots de positionnement situés sur les deux faces de celui-ci pour permettre un positionnement des modules lés uns par rapport aux autres lors de leur empilage et des moyens intégrés d'assemblage avec le module inférieur et/ou supérieur, ces moyens d'assemblage étant complémentaires, de façon à ce que le moyen d'un module soit verrouillé par le moyen du module placé immédiatement dessous ou dessus.

Avantageusement les alvéoles sont séparées entre elles d'un pas constant.

Avantageusement la fermeture et l'ouverture de chaque porte sont assurées par des moyens de verrouillage et de déverrouillage. Avantageusement les deux éléments de cheminée disposés sur la face de l'ensemble opposée aux ouvertures, associées à une poignée, permettent la préhension de celui-ci.

Avantageusement chaque ensemble comprend des moyens de positionnement, et des moyens de verrouillage à un autre ensemble qui lui serait associé.

Avantageusement chaque alvéole est dotée de moyens de sustentation et de blocage de l'objet plat qu'elle contient.

Avantageusement chaque ensemble est muni d'au moins un moyen d'identification de celui-ci.

Avantageusement chaque ensemble est muni d'au moins un capteur de pression interne.

Avantageusement les alvéoles sont munies de capteurs de présence d'objets.

Avantageusement chaque ensemble est muni de moyens permettant la fermeture étanche de chacune des portes, et ceci de façon indépendante, lesdits moyens servant également pour retirer chaque porte au moment de son ouverture.

Avantageusement, chaque ensemble est muni de moyens de transfert d'information vers les autres ensembles auxquels il est associé.

Avantageusement, selon l'invention, ces ensembles sont associables et dissociables entre eux, manuellement ou automatiquement.

Dans une variante de réalisation chaque ensemble est formé de plusieurs modules, chaque module comportant une alvéole. Chaque module, appelé module de base, est constitué d'une enceinte de part et d'autre de laquelle sont disposées deux coques.

Avantageusement l'enceinte est réalisée dans une matériau pris dans la famille des polycarbonates, légèrement chargé de fibres conductrices, qui protège les objets plats des contaminations moléculaires et chimiques, qui ne désorbe pas ni n'absorbe de contaminations moléculaires, et qui est suffisamment conducteur pour éviter l'accumulation des charges électrostatiques. De plus ce matériau est avantageusement léger.

Avantageusement un dépôt d'une couche à base de silice, rendue légèrement conductrice, pour évacuer les charges électrostatiques est réalisé à l'intérieur de l'enceinte.

Avantageusement des logements sont prévus dans les coques pour recevoir un mécanisme des baïonnettes, un verrou d'assemblage, une étiquette d'identification du module et/ou une étiquette radiofréquence réinscriptible, capable de mémoriser par exemple, l'identification de l'objet et/ou les informations sur l'état d'avancement du procédé appliqué à l'objet contenu dans l'enceinte.

Avantageusement les coques comportent des trous permettant le passage de plots de positionnement.

Avantageusement les deux coques, une fois assemblées autour de l'enceinte, réalisent un écran électrostatique et électromagnétique pour protéger l'objet situé à l'intérieur de l'enceinte de ce type de perturbation.

Avantageusement les coques sont réalisées en plastique chargé fortement de fibres conductrices pour les rendre très conductrices.

Avantageusement l'enceinte comprend :
- des plots de positionnement pour positionner les enceintes les unes par rapport aux autres lors de l'assemblage de différents modules ;
- un dispositif de verrouillage ;
- deux éléments de cheminée ;
- deux dispositifs permettant la sustentation des objets plats et de répartition de gaz ;
- une porte et les baïonnettes de manoeuvre.

Avantageusement les éléments de cheminée sont placés dans le même plan que l'enceinte de façon à ce que, lorsque l'on empile plusieurs modules pour former un ensemble, on obtienne les deux cheminées de l'ensemble.

Avantageusement le dispositif de verrouillage permet d'assembler des modules entre eux et permet d'effectuer la connexion électrique de masse pour permettre l'écoulement des charges électrostatiques accumulées sur les objets plats et dans les enceintes.

Avantageusement ce dispositif de verrouillage comporte des emplacements dans lesquels sont placés des capteurs.

Avantageusement le dispositif de verrouillage comprend un piton rapporté sur une excroissance réalisée sur le boîtier, cette excroissance possédant deux rainures dans lesquelles peut se déplacer le verrou pour réaliser l'assemblage.

Dans une variante de réalisation chaque module est réalisé en une seule pièce comportant au moins une zone transparente. Chaque module peut comprendre un nervurage de type « mâle-femelle ». La partie non transparente de chaque module peut être réalisée en polycarbonate chargée fibre de verre ou aiguille de silice, et la partie transparente en polycarbonate. Chaque module peut comprendre des flasques transparents rapportés sur un cadre ou être réalisé en un moulage bi-matière.

Dans une variante de réalisation le dispositif de l'invention comprend un système d'association des modules réalisé par des formes complémentaires ayant la forme d'oreillettes. Chaque module comprend de chaque côté une oreillette supérieure et deux oreillettes inférieures, les oreillettes inférieures étant dotées d'un mécanisme permettant d'associer les modules entre eux et d'exercer une pression suffisante pour assurer un positionnement précis et les étanchéités. Chaque mécanisme comprend un ergots présentant un pan en biseau solidaire d'un ressort permettant la rentrée de l'ergot dans l'oreillette inférieure correspondante. Chaque oreillette supérieure est dotée à chaque extrémité respectivement d'un coin apte à réagir lorsque deux modules sont positionnés l'un sur l'autre, à l'entrée des biseaux des ergots pour transformer la pression exercée sur ceux-ci en une force tendant à bloquer deux modules entre eux. Des doigts de manoeuvre solidaires des ergots se déplaçant dans des lumières réalisées dans les oreillettes inférieures permettent de manoeuvrer les ergots afin de désolidariser le module supérieur du module inférieur.

Le dispositif de verrouillage permet l'association de plusieurs modules, et/ou de plusieurs ensembles, ou d'au moins un module et d'au moins un ensemble.

Chaque porte est munie d'un moyen de blocage permettant de maintenir l'objet plat en contact avec deux butées situées sur chacun des dispositifs de sustentation pour assurer le positionnement et le maintien de l'objet dans le module.

Chaque dispositif permettant la sustentation d'un objet plat à la forme d'un tube percé. de trous permettant l'amenée et la répartition des gaz. Le blocage d'un objet est réalisé par deux butées réalisées aux premières extrémités des deux tubes servant d'amenée de gaz qui débouchent dans un élément de cheminée et par la porte et son moyen de blocage. Ce moyen de blocage peut être un ressort.

Dans une variante de réalisation le dispositif de l'invention comprend deux dispositifs de sustentation, situés de part et d'autre du module, réalisant un plénum avec la paroi interne de ce module permettant de répartir le gaz dans le module avec un flux transversal par un dispositif d'injection et d'évacuer le gaz par un dispositif d'échappement. Le blocage d'un objet est réalisé par un système de positionnement rigide en forme de coin solidaire de la porte, deux butées ressort, et deux éléments en forme de fourchette solidaires des dispositifs de sustentation. Les dispositifs de sustentation comprennent deux butées ressort et deux fourchettes, ces butées servant pour le maintien d'un objet plat, et pour repousser celui-ci en avant au moment de l'ouverture de la porte afin de le dégager des fourchettes.

Dans une variante de réalisation la porte comprend un joint, un corps et un dispositif de verrouillage du module, le joint venant en butée sur les dispositifs de sustentation lors le la fermeture de la porte. Le joint est armé avec une armature permettant de répartir convenablement la pression du joint sur tout le périmètre du nez du module. Le joint comporte un logement en forme de coin apte à bloquer l'objet plat.

Chaque module comprend des moyens de positionnement pour positionner les modules les uns par rapport aux autres, des moyens de verrouillage à un autre module qui lui serait associé, des moyens d'ouverture de porte, des moyens de sustentation d'objet et de répartition des gaz.

Dans une variante de réalisation, chaque module comprend des moyens d'identification et/ou des moyens capteur de contrôle et des moyens de transfert d'information vers les autres modules.

La structure d'un module est telle qu'une variation de ±3000 Pascal de la pression interne par rapport à la pression extérieure n'entraîne aucune modification des fonctionnalités et des étanchéités.

Avantageusement, dans chaque ensemble, un joint est disposé entre deux éléments de cheminée correspondant respectivement à deux modules différents de façon à assurer l'étanchéité entre deux modules consécutifs, ces modules étant appelés modules intermédiaires.

Toutefois un ensemble dit "unitaire" peut être formé d'un seul module contenant une alvéole.

Avantageusement, les éléments de cheminée reçoivent, selon la nature du module auquel ils appartiennent, un joint à chaque extrémité dans le cas d'un module intermédiaire, un joint pour la face associée à un module intermédiaire et un connecteur pour la face susceptible d'être connectée à un autre ensemble dans le cas d'un module terminal, ou un connecteur à chaque extrémité dans le cas où un module est un ensemble unitaire.

Dans une variante de réalisation les éléments de cheminée reçoivent un élément de filtration permettant le filtrage des particules qui pourraient être libérées lors de la connexion/déconnexion de modules. L'élément de filtration comprend une couronne centrale composée d'une couronne rigide sur laquelle est rapportée une membrane filtrante. Avantageusement le connecteur autobloquant comprend un clapet monté sur un ressort guidé par un flasque monté étanche grâce à un joint sur l'élément de cheminée correspondant, un joint à lèvre permettant d'assurer l'étanchéité entre éléments de cheminée, et des formes complémentaires.

Dans une autre variante de réalisation, l'élément de filtration comprend une couronne en matière filtrante. Le connecteur autobloqueur comprend une membrane élastique en forme de tripode venant se loger dans un emplacement aménagé dans la partie inférieure d'un flasque muni sur sa face inférieure d'une portée conique.

Chaque ensemble est doté de moyens de verrouillage manuels ou automatiques à un autre ensemble unitaire ou non qui lui serait associé permettant l'association et la dissociation d'au moins deux ensembles unitaires ou non.

On assemble un ensemble En+1 sur un ensemble En par action sur un levier du mécanisme d'assemblage appartenant à l'ensemble En afin de ne pas dépositionner En+1 par rapport à En, En étant déjà bloqué par rapport à En-1.

Ce procédé d'assemblage est applicable pour l'assemblage de modules. Pour réaliser des ensembles à partir de modules unitaires, après avoir réaliser un empilement de modules, on retire tous les leviers de manoeuvre des modules intermédiaires, on ne conserve que celui du module terminal haut, qui sert à l'amarrage d'un autre ensemble.

Dans un exemple de réalisation de l'invention particulièrement avantageux les objets plats sont des plaques de semi-conducteur.

L'invention concerne également un procédé de transfert d'un objet plat d'une alvéole du dispositif décrit ci-dessus, dans une machine de traitement, caractérisé en ce que ledit dispositif est positionné de telle sorte que chaque alvéole puisse être mise en communication avec ladite machine afin qu'un robot, dont est dotée ladite machine, puisse effectuer un transfert dudit objet dans un sens ou dans l'autre tout en préservant l'environnement de pureté et de propreté entourant l'objet durant le transfert.

Avantageusement pour réaliser une connexion on a les étapes suivantes :
- positionnement du dispositif de l'invention sur le plateau de la machine ;
- positionnement d'au moins une alvéole en face du mors mobile de la bride ;
- raccordement étanche entre au moins une alvéole du dispositif de l'invention avec la machine par déplacement du mors mobile de la bride grâce à un mécanisme de translation solidaire de la bride ;
- purge du volume mort entre la porte de l'alvéole et la porte du mors mobile ;
- mise en contact de la porte de l'alvéole sur la porte du mors mobile, en actionnant les baïonnettes associées à l'alvéole par un mécanisme solidaire de la partie fixe de la bride, l'action sur les baïonnettes permettant aussi de solidariser les deux portes ;
- ouverture simultanée des deux portes ainsi solidarisées pour emprisonner les contaminations à l'interface, cet escamotage, réalisé par un mécanisme solidaire du mors mobile des deux portes à l'intérieur du mors mobile, libérant un espace suffisant au passage du doigt du robot interne de la machine pour prendre ou déposer un objet plat dans l'alvéole (par exemple une plaque de silicium) ;
- transfert de l'objet plat par le robot ;
- isolation sur le plan contamination de l'alvéole et de la machine : on réalise un flux de gaz approprié dans le mors mobile afin d'isoler sur le plan contamination l'intérieur de l'enveloppe par rapport à la machine pour éviter la contamination des alvéoles au moment du transfert de l'objet plat ; toutefois, dans le cas des équipements "vide", il n'y a pas d'injection de gaz mais liaison au circuit de vide ;
- fermeture simultanée par le mécanisme de bride des deux portes maintenues en contact ; une fois la position atteinte, la porte du mors mobile fermant de façon étanche la machine, alors que la porte de l'alvéole ne ferme pas l'alvéole de façon étanche ;
- reconditionnement de l'atmosphère de l'alvéole avant fermeture : dans cette position on reconditionne la pureté dans l'enveloppe en injectant un gaz approprié ; toutefois on ne réalise pas cette opération pour les équipements "vide" ;
- désolidarisation des deux portes par action du mécanisme sur la bride, sur les baïonnettes de la porte de l'alvéole et recul de la porte de l'alvéole jusqu'à fermer de façon étanche l'alvéole ;
- retrait du mors mobile par action du mécanisme de transfert solidaire de la bride ;
- possibilité, alors, d'indexer pour ouvrir une autre alvéole ou bien de retirer le dispositif de l'invention de la machine.

Avantageusement on utilise au moins une bride comportant une partie mobile, fermée par une porte, qui avance vers au moins une alvéole à ouvrir afin de réaliser une liaison étanche entre la machine et l'alvéole. Un mors mobile est raccordé à la partie fixe de la bride par un soufflet pour assurer la translation et garantir l'étanchéité avec la machine. Dans le cas du raccordement des équipements "vide" ce soufflet est métallique. La bride est dotée de moyens permettant d'ouvrir la porte de l'alvéole et la porte fermant la bride afin de réaliser un tunnel de communication étanche dans lequel le robot de la machine peut réaliser le transfert de l'objet.

La porte, qui est indépendante de l'alvéole correspondante et amovible, est complètement désolidarisée de celle-ci au moment de l'ouverture pour libérer complètement le passage du robot.

Dans un exemple de réalisation un mécanisme, qui permet de verrouiller la porte pour fermer l'alvéole, est commandé et animé par un mécanisme complémentaire solidaire de la porte de la bride d'ouverture. L'association de ces deux mécanismes déverrouille la porte fermant l'alvéole et libère celle-ci, ces deux mécanismes étant alors solidarisés.

Grâce à plusieurs mécanismes dont est munie la bride, on réalise l'avance ou le recul du mors mobile, on vient engager deux butées solidaires d'un mécanisme d'oreillettes, de part et d'autre de l'alvéole pour que le mors mobile puisse venir exercer une pression sur l'alvéole pour assurer l'étanchéité sans dépositionner le dispositif de l'invention ; un mécanisme actionne les baïonnettes pour assurer le transfert de la porte de l'alvéole sur la porte du mors mobile et libérer cette porte pour permettre son escamotage dans le mors mobile ; grâce à un mécanisme dont est doté le mors mobile on peut réaliser l'escamotage des deux portes.

Avantageusement on contrôle, avant l'accostage, la position de l'alvéole à ouvrir. Le contrôle de la position du doigt du robot ou de l'objet est réalisé au moment de la prise ou de la dépose d'un objet de façon à réaliser cette opération sans frottement. L'identification de l'objet peut être lue à la volée par un dispositif électro-optique.

Avantageusement deux butées solidaires d'un mécanisme d'oreillettes permettent de maintenir un positionnement précis du dispositif de l'invention alors que le mors mobile qui est muni d'un joint, exerce une pression sur son joint afin d'assurer l'étanchéité avec l'alvéole considérée.

Avantageusement la bride est munie de moyens qui permettent de purger les volumes morts et de restaurer l'environnement pur de l'alvéole avant de la fermer. Elle est aussi muni de moyens permettant de contrôler la position dudit dispositif, de contrôler la position relative de l'objet au moment de son transfert, et de lire son identifiant, pendant son transfert.

Avantageusement lorsque la machine met en oeuvre un procédé réalisé sous vide et qu'elle est nécessairement munie d'un sas de transfert, le dispositif de l'invention appelé aussi cassette, peut 5 être installé dans le sas. Dans ce cas on réalise simultanément le vide dans les différentes alvéoles du dispositif grâce aux cheminées et dans le sas de transfert de celui-ci.

Ensuite l'interfaçage se fait comme décrit précédemment pour le transfert d'objets vers les machines dont les procédés sont réalisés dans le vide sans rupture de la chaîne de propreté et/ou de pureté entourant les objets et surtout sans nécessité d'opérations supplémentaires pour sortir les objets des alvéoles et les réintroduire dans le sas de la machine. Cette descente en vide, simultanément dans chaque alvéole, est assurée et régulée par un moyen exploitant les informations des capteurs de pression installés dans la cassette et dans le sas. Ce moyen comporte un dispositif de pompage. Les mêmes moyens permettent également remonter à la pression atmosphérique par contrôle de l'injection d'azote en simultanéité dans le sas et dans les alvéoles.

L'invention permet de rendre les plaques de semi-conducteur accessibles par le robot interne des équipements, sans nécessiter de robot supplémentaire.

Les principaux avantages de l'invention par rapport aux dispositifs de l'art antérieur sont explicités notamment sur le tableau I en fin de description.

### Brève description des dessins

- Les figures 1 à 3 illustrent différents dispositifs de l'art antérieur, les figures 1A, 2A et 3A correspondant aux zones de travail et les figures 1B, 2B et 3B correspondant aux zones de transfert et de stockage ;
- les figures 4 à 8 illustrent d'autres dispositif de l'art antérieur ;
- les figures 9 et 12 illustrent une première réalisation du dispositif de l'invention ;
- les figures 13 à 20 illustrent une seconde réalisation du dispositif de l'invention à base de modules ; les figures 14 et 16 à 20 illustrant différentes caractéristiques d'un module de base du dispositif de l'invention ;
- la figure 21 illustre un élément de cheminée muni de deux connecteurs permettant la liaison avec des éléments voisins ;
- le figure 22 illustre le procédé selon l'invention de transfert d'objets plats entre le dispositif de l'invention et une machine de traitement ;
- la figure 23 illustre un système de mise sous vide du dispositif selon l'invention ;
- les figures 24 à 38 illustrent différentes variantes de réalisation du dispositif de l'invention.

### Exposé détaillé de modes de réalisation

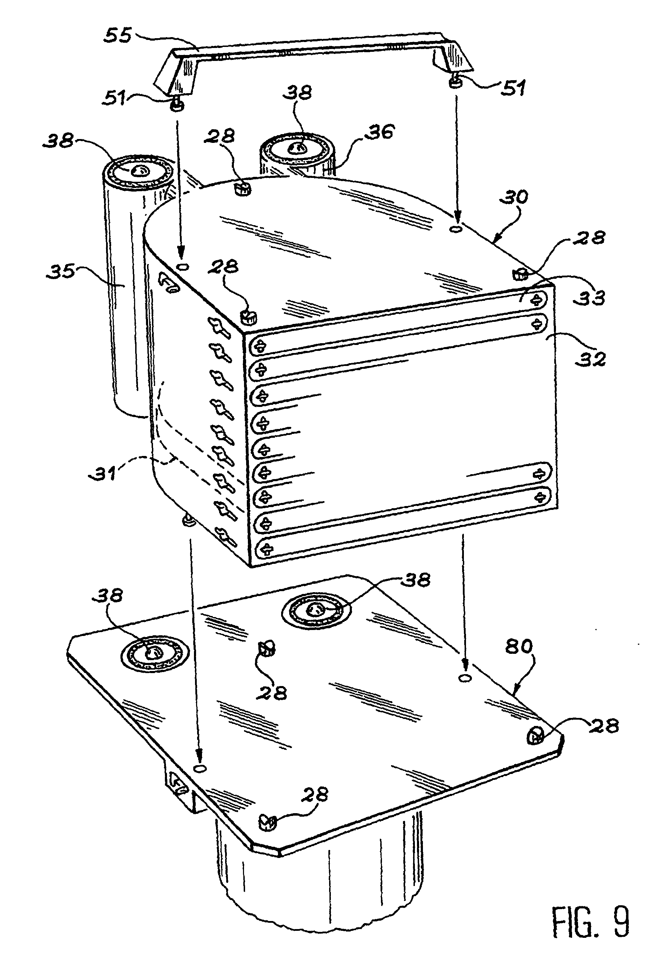

La présente invention concerne un dispositif de transport d'objets plats 10, par exemple des plaques de semi-conducteur, confinés dans une atmosphère déterminée. Ce peut être par exemple, comme représenté sur la figure 9, un ensemble 30, en plastique ou en métal, muni d'une ou de plusieurs alvéoles plates 31, ici neuf, de faible épaisseur, débouchant sur une face latérale 32 dudit ensemble, disposées en parallèle, réunies entre elles d'un point de vue aéraulique. Chaque alvéole est apte à recevoir un objet plat 10 et à être fermée par une porte 33 indépendante s'étendant sur toute la longueur de cette face latérale. Chaque porte 33 est séparable de l'ensemble. La fermeture et l'ouverture de chaque porte 33 sont assurées par un dispositif de verrouillage et de déverrouillage. les alvéoles 31 sont séparées entre elles d'un pas constant.

Chaque ensemble 30 comporte un élément de cheminée d'amenée de gaz 35 et un élément de cheminée de retour de gaz 36. Ces deux éléments de cheminée disposés sur la face de l'ensemble 30 opposée aux ouvertures, associés à une poignée 55, permettent la préhension de celui-ci. Cette poignée 51 de manipulation du dispositif de l'invention peut être assemblée comme un autre ensemble 30 sur la face supérieure de ce dispositif.

Les éléments de cheminée 35 et 36 sont terminés par un connecteur auto-obturant 38.

Chaque ensemble 30 comprend des moyens de positionnement des différents ensembles entre eux 28, des moyens d'assemblage 51 à un autre ensemble qui lui serait associé, des moyens d'identification, des moyens de sustentation d'objet dans chaque alvéole et de répartition des gaz, des moyens capteur de contrôle et des moyens de transfert d'information vers d'autres ensembles qui lui seraient associés.

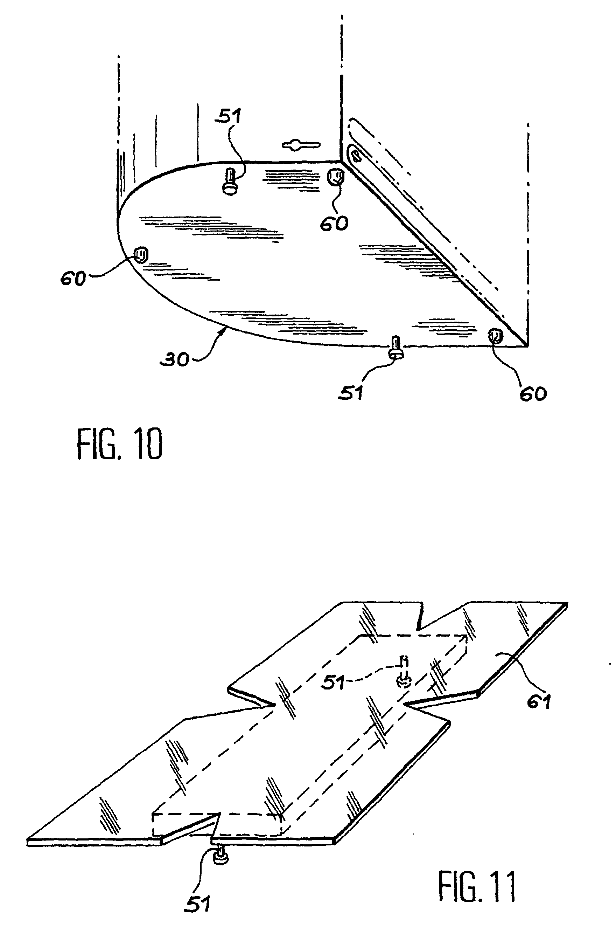

Sur la figure 9 est également représenté un plateau 80 sur lequel peut être disposé le dispositif de l'invention. La figure 10 illustre la face inférieure du dispositif de l'invention munie de picots 51 et de plots de positionnement 60. La figure 11 illustre un plateau 61 compatible pour la prise par un robot avec le même mode d'assemblage que la poignée 55.

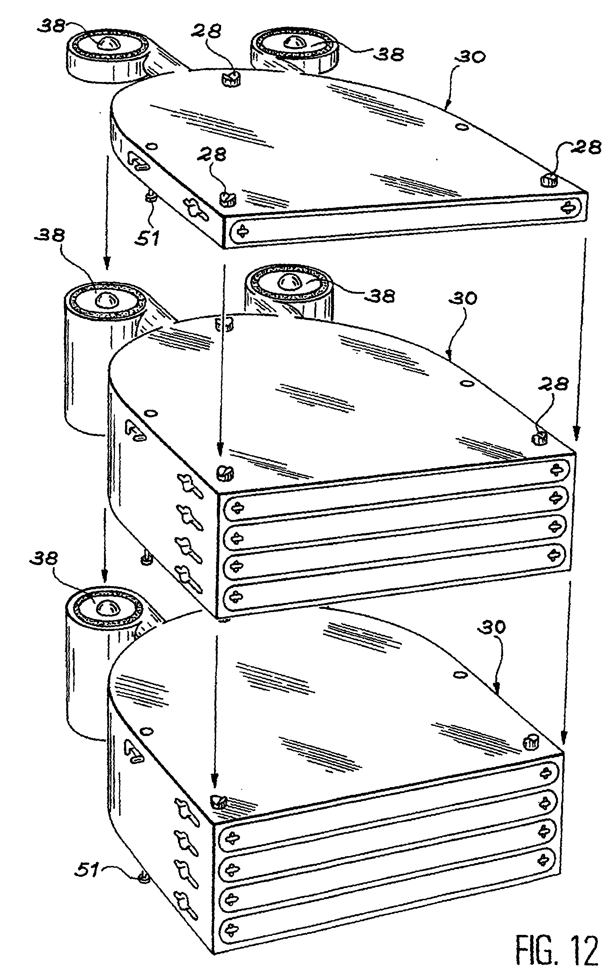

Comme représenté sur la figure 12 le dispositif de l'invention appelé cassette peut être constitué d'un ou de plusieurs ensembles 30 tels que définis ci-dessus, associés entre eux, chaque ensemble comportant une ou plusieurs alvéoles.

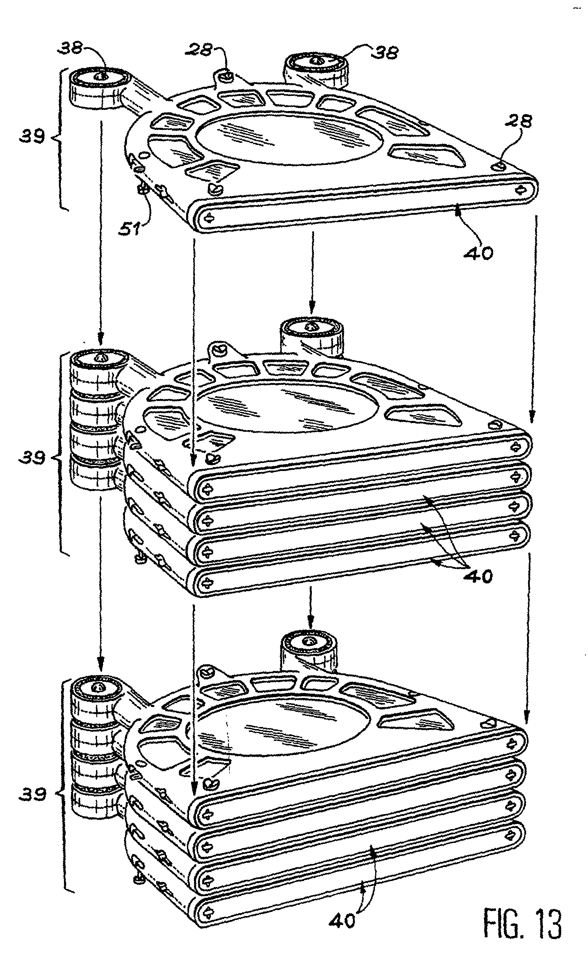

Dans une variante de réalisation illustrée sur la figure 13, le dispositif de l'invention est formé d'un ou de plusieurs ensembles 39 ; mais chaque ensemble 39 est lui-même constitué d'un ou plusieurs modules 40 associés mécaniquement entre eux de manière indissociable, telle qu'à chaque alvéole correspond à présent un module indépendant. Quelle que soit la constitution de la cassette, ces différents ensembles constitutifs sont dissociables lors du nettoyage et peuvent être associés à la demande pour réaliser un autre lot de traitement d'objets plats, cette nouvelle association étant figée pour tout un cycle.

Sur la figure 13 est représenté, à titre d'exemple, un ensemble 39 formé d'un seul module 40 et deux ensembles 39 formés de quatre modules 40.

Le module unitaire 40 peut être utilisé pour recevoir un objet 10, par exemple une plaque de semi-conducteur, servant de référence.

Les ensembles constitués d'un seul bloc comme illustré sur la figure 9, ou d'un ou plusieurs modules comme illustré sur la figure 13, sont associables et dissociables entre eux pour obtenir un dispositif de transport d'utilisation flexible, c'est-à-dire adapté au besoin de l'opérateur, le pas entre les différentes alvéoles, même au raccordement de deux ensembles, restant le même.

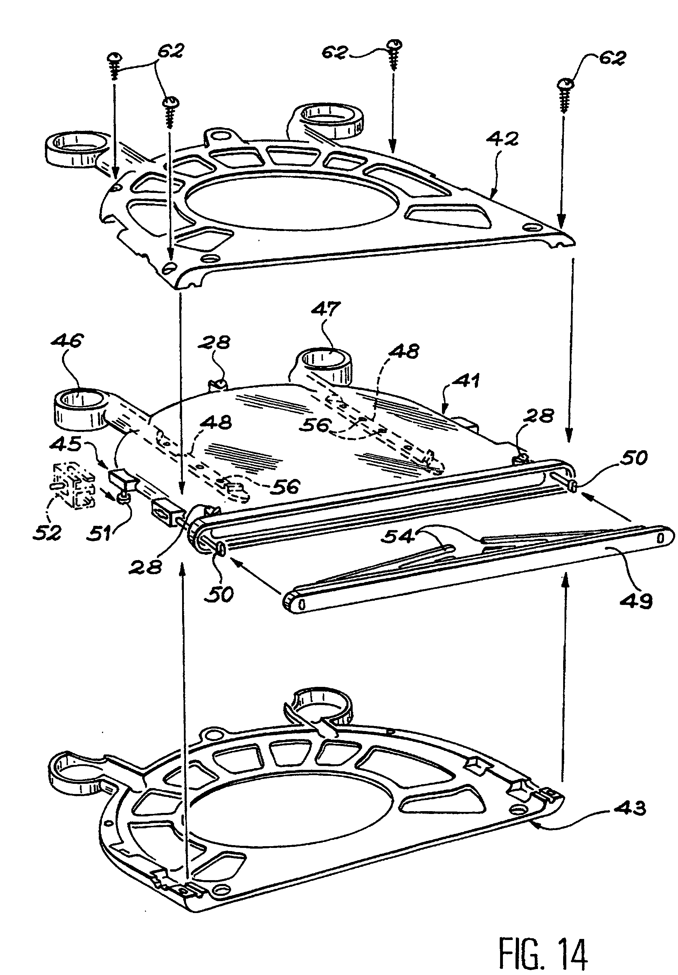

Comme représenté sur la figure 14, un module de base 40 est constitué une enceinte 41 de part et d'autre de laquelle sont disposés deux coques 42 et 43 assemblées entre elles, protégeant l'enceinte 41.

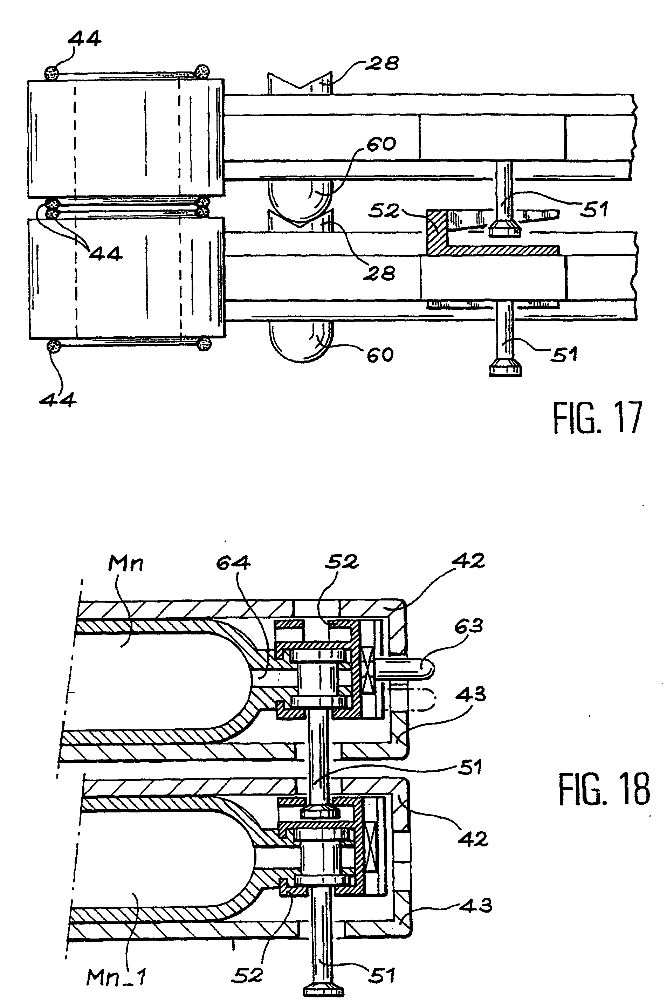

Cette enceinte 41 comprend :
- des plots de positionnement 60 illustrés notamment sur la figure 17 pour positionner les enceintes les unes par rapport aux autres lors de l'assemblage des différents modules ;
- un dispositif d'assemblage 45 ;
- des éléments de cheminée 46 et 47 ;
- deux dispositifs 48 permettant la sustentation des objets plats et de répartition de gaz à l'intérieur de l'enceinte ;
- une porte 49 pour fermer de façon étanche l'enceinte 41 et les baïonnettes de manoeuvre 50 pour ouvrir et fermer et maintenir la porte fermée, pour faire avancer la porte dans la bride de raccordement et pour la libérer afin de permettre l'escamotage de la porte dans la bride.

L'enceinte 41 est réalisée idéalement dans un matériau qui protège les objets plats 10 des contaminations moléculaires et chimiques, qui ne désorbe pas ni n'absorbe de contamination moléculaire, suffisamment conducteur pour éviter l'accumulation des charges électrostatiques et avantageusement léger. Dans la pratique, on peut utiliser des matériaux pris dans la famille des polycarbonates légèrement chargés de fibres conductrices.

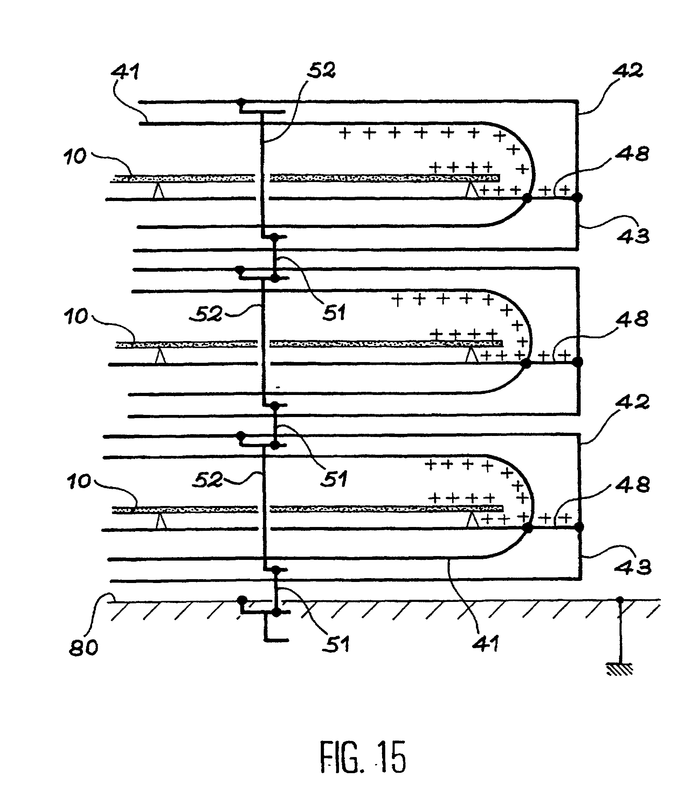

Pour l'application micro-électronique, afin de garantir le degré de pureté requis, on peut procéder à un dépôt à l'intérieur de l'enceinte 41 d'une couche à base de silice rendue légèrement conductrice pour évacuer les charges électrostatiques. Ces charges sont écoulées à la masse par le système de sustentation, lui-même connecté aux coques de protection de l'enceinte comme représenté sur la figure 15. L'assemblage de ces deux coques réalise aussi un écran électrostatique et électromagnétique pour protéger l'objet situé à l'intérieur de l'enceinte de ce type de perturbation.

Les coques 42 et 43 sont, par exemple, réalisées en plastique chargé fortement de fibres conductrices pour les rendre très conductrices.

Les coques 42 et 43 comportent des trous permettant le passage des plots de positionnement. Les deux coques qui entourent l'enceinte sont assemblées entre elles, par exemple avec des vis 62, et ont pour rôle de protéger l'enceinte. Des logements sont prévus dans ces coques pour recevoir le mécanisme de baïonnettes 50, le verrou d'assemblage 52, et avantageusement une étiquette d'identification du module et/ou une étiquette radiofréquence réinscriptible, capable de mémoriser par exemple, l'identification de l'objet 10 et/ou les informations sur l'état d'avancement du procédé appliqué à l'objet contenu dans l'enceinte.

Le dispositif d'assemblage 45 permet d'assembler des modules entre eux et permet d'effectuer la connexion électrique de masse pour permettre l'écoulement des charges électrostatiques accumulées sur les objets plats et dans les enceintes. Ce dispositif d'assemblage comporte des emplacements dans lesquels seront placés des capteurs.

Les éléments de cheminée reçoivent, selon la nature du module auxquels il appartiennent, un joint 44 à chaque extrémité dans le cas d'un module intermédiaire, un joint 44 à une extrémité et un connecteur 38 à l'autre dans le cas d'un module terminal, ou un connecteur 38 à chaque extrémité dans le cas où un module est un ensemble unitaire.

Les dispositifs 48 pour la sustentation des objets plats et de répartition de gaz à l'intérieur de l'enceinte sont rapportés dans l'enceinte.

Les baïonnettes de manoeuvre permettent évidemment les opérations inverses à celles décrites.

Avantageusement l'enceinte comprend différents capteurs, par exemple un capteur de pression ou de présence d'oxygène, situés dans des logements prévus à cet effet par exemple le logement 64.

La porte 49 réalise une fermeture étanche du module 40 par la pression d'un joint, par exemplaire plan ou « genouillère », solidaire de la porte sur une forme adaptée, par exemple de type « couteau », du module. La pression est assurée par les baïonnettes de manoeuvre 50 dotées d'un ressort de rappel.

Comme représenté sur les figures 14, 17 et 18, le dispositif d'assemblage 45 comprend un piton 51 rapporté sur une excroissance réalisée sur le enceinte 41, cette excroissance possédant deux rainures dans lesquelles peut se déplacer le verrou 52 pour réaliser l'assemblage des enceintes de deux modules successifs Mₙ₊₁ et Mₙ. Le verrouillage du module Mₙ₊₁ est réalisé par action sur le module Mₙ, Mₙ étant déjà bloqué.

Sur la figure 18 le module supérieur est un module terminal haut Mₙ d'un ensemble et comporte un levier 63 qui lui permet de déverrouiller un ensemble Mₙ₊₁ qui lui serait superposé. Les modules intermédiaires ou bas Mₙ₋₁ ..., constituant un ensemble, sont non déverrouillables et ne comportent pas un tel levier parce que celui-ci a été enlevé pour qu'ils puissent constituer un tel ensemble.

Comme représenté sur la figure 14 la porte 49 est munie d'un ressort 54 de blocage de l'objet plat 10.

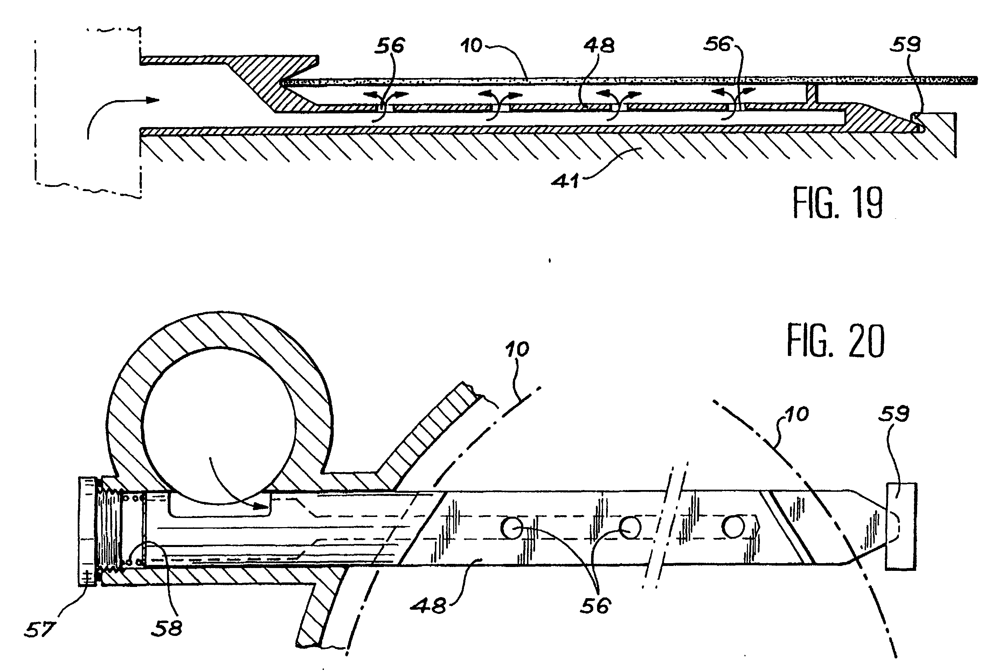

Un dispositif 48 permettant la sustentation de l'objet plat 10, illustré sur les figures 14, 16, 19 et 20 a la forme d'un tube 55 réalisé, par exemple, par une tige pleine dans laquelle est percé un orifice qui va en se rétrécissant, cet orifice étant percé de trous 56. Le blocage de l'objet 10 est réalisé par deux butées maintenant l'objet en position, réalisées aux premières extrémités des deux tubes 55 et par la porte et son ressort de blocage.

Le bouchon 57 et le ressort 58 permettent de maintenir le tube 55 dans son logement. Un logement 59 est prévu dans le boîtier 41 pour blocage de ce tube 55.

Le matériau de ce tube est par exemple du plastique de type PEEK conducteur permettant de maintenir le potentiel de l'objet à la masse et de conduire les charges électrostatiques vers les coques conductrices 42 et 43, elles-mêmes maintenues à la masse. Le bouchon 57 et le ressort 58 assurent le contact électrique.

Ce dispositif 48 est également utilisé pour répartir le gaz dans l'enceinte.

Dans un mode avantageux de l'invention, les alvéoles peuvent être réalisées dans un plastique résistant à des températures d'environ 120°C pouvant alors être utilisées pour réaliser un procédé de traitement des objets. Par exemple, elles peuvent ainsi être utilisées pour stabiliser un procédé d'implantation ionique : en contrôlant la température de l'azote injecté, on peut contrôler parfaitement le refroidissement des objets.

Avantageusement l'enceinte 41 peut être réalisée dans un matériau compatible avec les spécifications de l'objet confiné.

Pour les plaques de silicium, cette enceinte doit être en plastique pour des raisons de légèreté. Pour des applications où il n'est pas nécessaire de voir les plaques cette enceinte peut être réalisée dans des matériaux de type polycarbonate chargés de fibres conductrices pour écouler les charges électrostatiques.

Pour des applications où il est nécessaire de conserver la transparence et où les conditions d'environnement sont très sévères en terme de dégazage, on utilise du polycarbonate revêtu à l'intérieur d'une couche barrière de moins de 1 micromètre de silice convenablement dopé en silicium pour la rendre légèrement conductrice, sans perte de la transparence.

Les deux coques 42, 43 constituant le boîtier de protection et de maintien de l'enceinte peuvent être réalisées en plastique conducteur.

Les charges électrostatiques créées sur les faces internes de l'enceinte et celles véhiculées par l'objet vont être écoulées vers le boîtier conducteur par le mécanisme de sustentation (48), lui-même conducteur grâce au contact réalisé par le ressort (57) et le bouchon (58). Le verrou 52 en connexion avec la coque par un ressort va écouler les charges sur le verrou du module sous-jacent via le piton conducteur 51, créant ainsi une chaîne de "masse" jusqu'au plateau conducteur sur lequel est positionné le mécanisme de l'invention, plateau raccordé à la masse, comme représenté sur la figure 15.

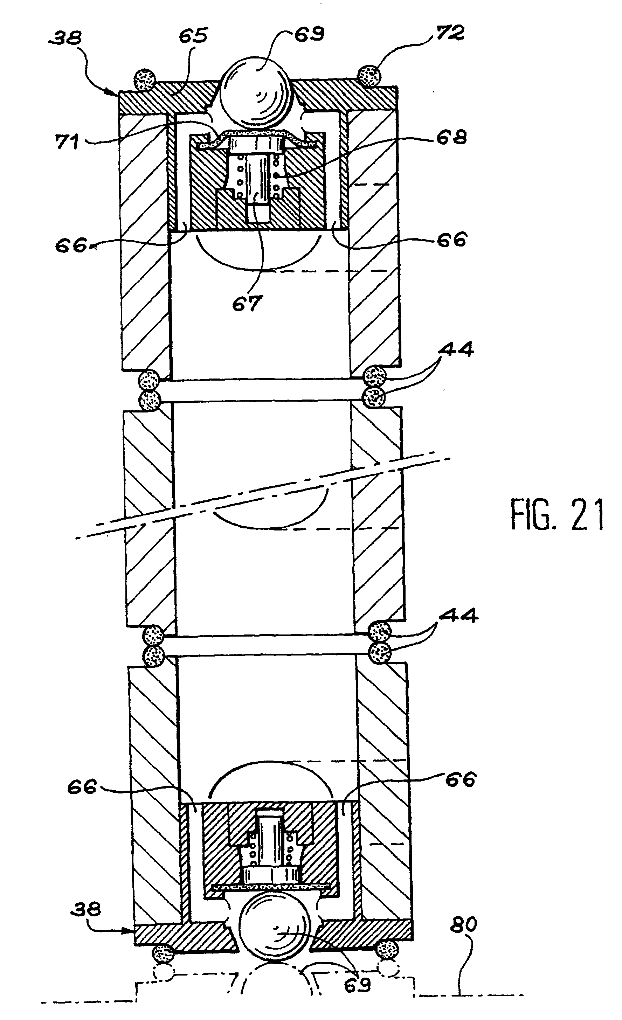

Un connecteur auto-obturant 38, comme illustré sur la figure 21, permet d'assurer d'une part l'étanchéité des volumes intérieurs des enceintes pour les extrémités non connectées, et d'autre part la continuité de la distribution de gaz pour les parties connectées.

Un tel connecteur 38 comprend un corps 65, muni de deux canaux 66 permettant le passage du gaz, à l'intérieur duquel un système poussoir 67, actionné par un ressort 68, est apte à repousser une bille 69 disposée dans un siège muni d'un chanfrein 70, une membrane 71 de protection contre la contamination du ressort étant disposée entre le système poussoir 67 et la bille 69. Un joint torique 72 est disposé sur la périphérie extérieure supérieure de ce corps.

Lorsque deux connecteurs de ce type sont reliés l'un à l'autre, l'étanchéité est réalisée grâce aux joints, et l'appui des deux billes l'une sur l'autre permet la mise en communication des canaux de passage de gaz entre eux : sur la figure 21 le connecteur auto-obturant 38 situé en bas est représenté en connexion avec un même connecteur disposé sur un plateau 80 représenté en tiretés.

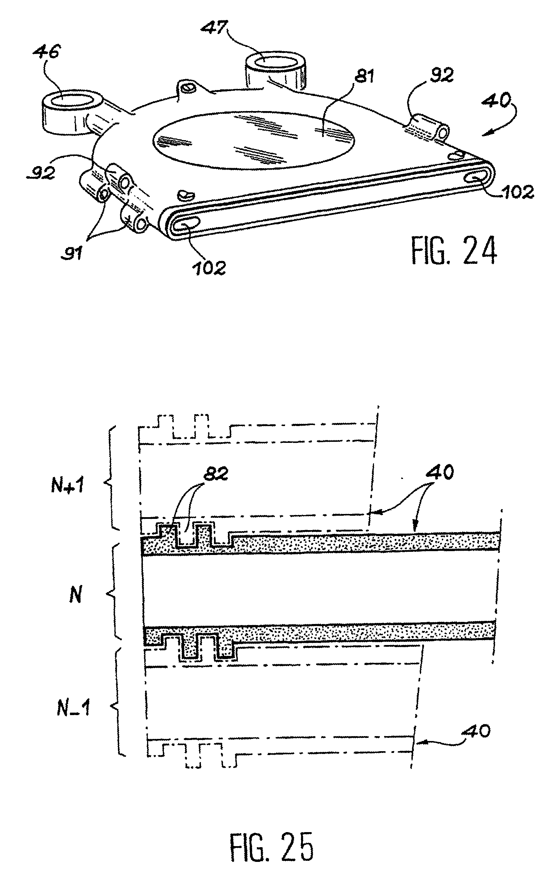

Dans une variante de réalisation, illustrée sur la figure 24, le module de base 40 est réalisé en une seule pièce transparente, pour pouvoir identifier et observer l'objet plat 10 situé à l'intérieur. Cette pièce peut être totalement transparente, ou au minimum transparente dans les zones 81 en regard de l'objet plat 10. Sur la figure 24 est représentée une telle zone minimum 81.

On peut ainsi observer et identifier l'objet plat, par exemple la plaque de silicium 10 à l'intérieur du module 40 sans avoir à la sortir, c'est-à-dire en la maintenant dans son environnement ultrapur et/ou ultra-propre.

Comme illustré sur la figure 25 un nervurage spécial 82 de type « mâle-femelle » peut permettre d'accroître la rigidité du module 40, aussi bien au niveau du « nez » du module, qu'au niveau des cheminées d'admission de gaz.

A titre d'exemple on peut réaliser la partie non transparente très rigide en polycarbonate chargé fibre de verre ou aiguille de silice, et la partie transparente en polycarbonate. On peut, pour ce faire, utiliser des plaques transparentes rapportées sur un cadre par soudage ou à force avec un joint, ou un moulage bi-matière.

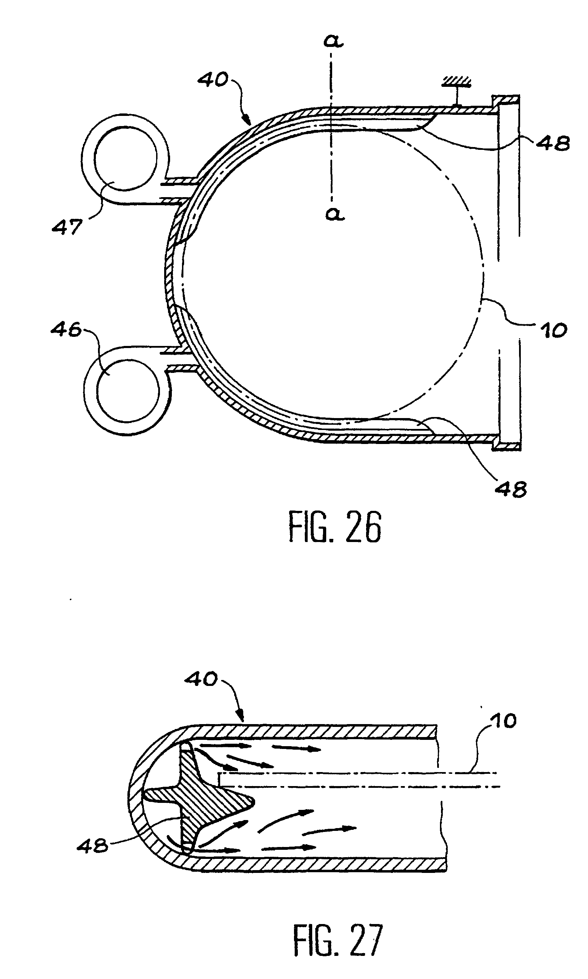

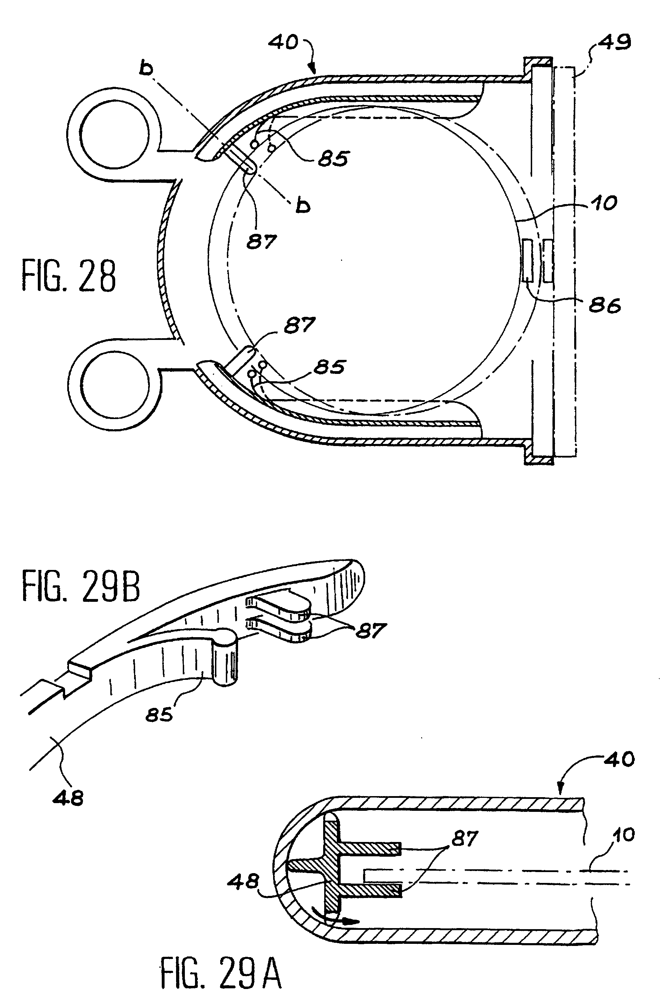

Dans une variante de réalisation, comme illustré sur les figures 26 à 29, la forme des dispositifs 48 pour la sustentation des objets plats 10 et le mode de diffusion de gaz sont modifiés ; la figure 27 illustrant une coupe a-a de la figure 26 et la figure 29A illustrant une coupe b-b de la figure 28.

Comme illustré sur la figure 27 chaque dispositif 48, situé de part et d'autre du module 40, a une coupe se rapprochant de la forme d'un « T » qui permet de réaliser un flux de gaz horizontal et transverse à l'objet plat. En effet la partie interne du module 40 et chaque dispositif 48 réalisent un « plénum » permettant de répartir le gaz dans le module par un dispositif 48 d'injection et d'évacuer le gaz par un dispositif 48 d'échappement.

Chaque dispositif 48 reste conducteur pour écouler les charges et maintenir l'objet plat 10 à un potentiel électrique voisin de la masse.

La fonction blocage de l'objet plat 10 est assurée par un système de positionnement rigide 86 en forme de « coin » solidaire de la porte 49. L'effet « blocage », positionnement de l'objet plat 10, porte fermée ou porte ouverte, est assuré par deux butées ressort 85 et deux éléments 87 en forme de fourchette solidaires du système de sustentation 48, comme illustré sur la figure 29B, empêchant l'objet plat 10 de bouger dans le module 40.

Lorsque la porte 49 est ouverte, les butées ressort 85 repoussent légèrement l'objet plat 10 vers l'avant pour le libérer des éléments 87 permettant, ainsi, à l'objet plat 10 d'être pris par un robot de préhension.

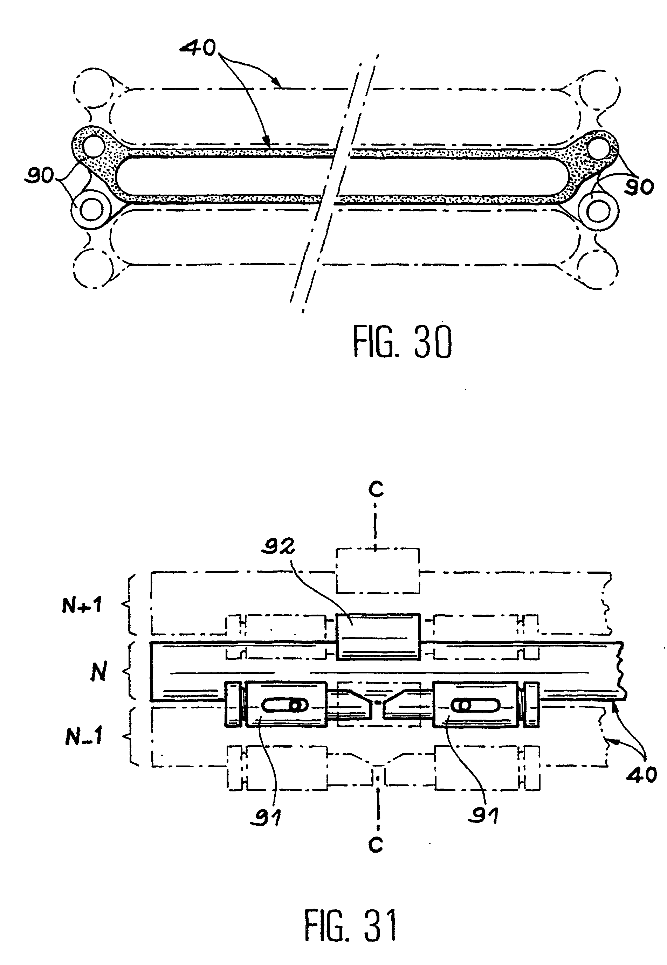

Dans une variante de réalisation le système d'association des modules 40, comme illustré sur la figure 24, est obtenu comme illustré sur les figures 30 et 31 en utilisant des formes complémentaires 90 sous forme d'oreillettes, la figure 30 illustrant une coupe c-c de la figure 31. Chaque module 40 comporte, de chaque côté, une oreillette supérieure 92 et deux oreillettes inférieures 91. Ces oreillettes 91 et 92, dont le rôle pourrait être inversé, sont réalisées sur chacun des modules 40 pour permettre leur empilage et pour amener en correspondance deux oreillettes inférieures 91 d'un module N avec l'oreillette supérieure 92 complémentaire d'un module N-1.

Un mécanisme logé dans les oreillettes inférieures 91 permet d'une part de venir verrouiller les modules 40 entre eux et d'autre part, de venir plaquer les modules 40 les uns sur les autres pour garantir le positionnement relatif et la pression nécessaire pour obtenir l'étanchéité de l'empilage des différents éléments de cheminée.

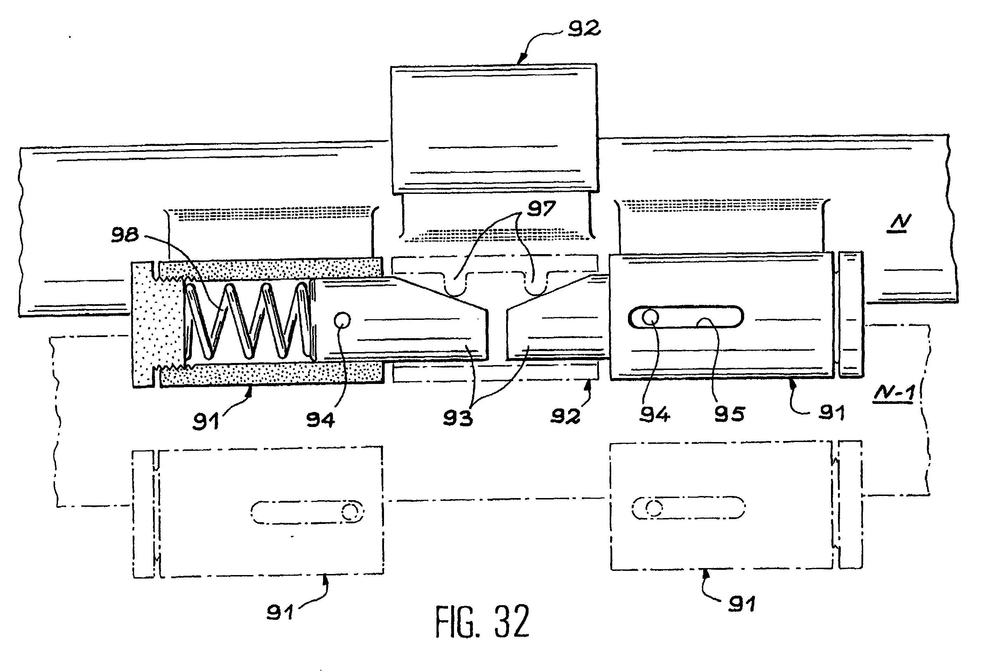

La figure 32 illustre les mécanismes logés dans les deux oreillettes inférieures 91 d'un module 40 de rang N et leur mode de fonctionnement.

Deux ergots 93 présentant un pan en biseau pénètrent dans l'oreillette supérieure 92 du module 40 de rang N-1. Cette oreillette supérieure est dotée de deux coins 97 qui font réaction aux biseaux des ergots 93 et transforment la pression exercée sur les ergots 93 par les deux ressorts 98 en une force tendant à bloquer le module 40(N) sur le module 40(N-1).

Des doigts de manoeuvre 94 solidaires des ergots 93 se déplaçant dans une lumière 95 réalisée dans les oreillettes inférieures 91 permettent de manoeuvrer les ergots afin de pouvoir désolidariser le module supérieur N du module inférieur N-1.

Les oreillettes 91 et 92 peuvent être soit rapportées sur le module 40, soit faire partie de ce module.

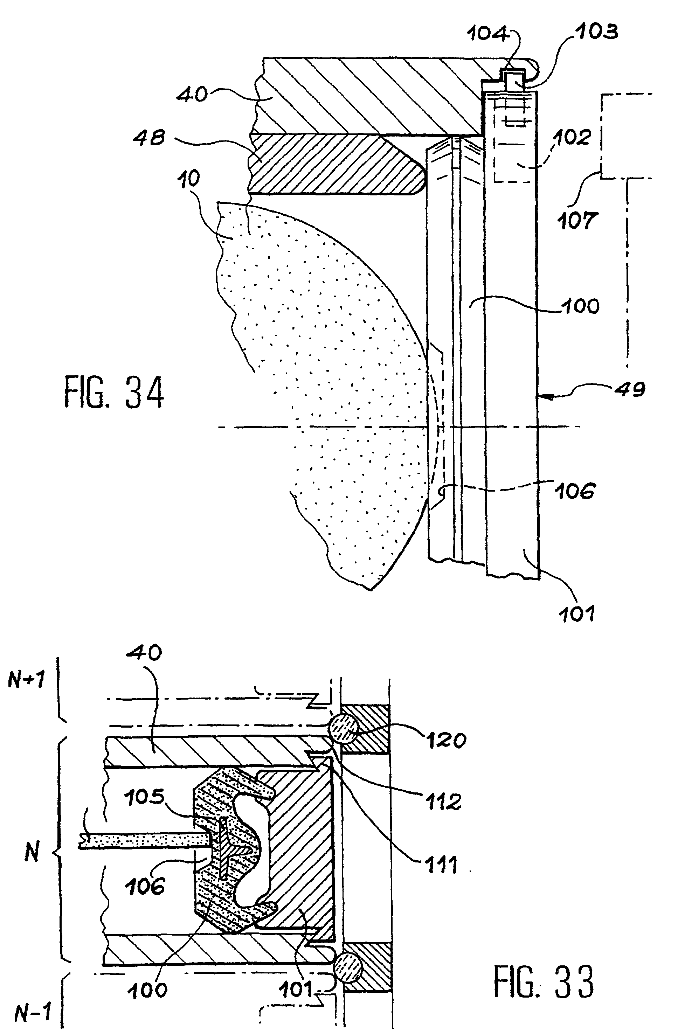

Dans une variante de réalisation illustrée sur les figures 33 et 34, la porte 49 du module 40 est composée de trois parties, un joint 100, un corps 101 sur lequel le joint est monté et un dispositif de verrouillage 102 pour lier la porte avec le module 40. Le joint 100 vient en butée sur les dispositifs de sustentation 48 des objets plats 10 situés de part et d'autre du module 40. La pression sur le joint 100 est assurée par une pression sur le corps de la porte 49 au moment de la fermeture de celle-ci, pression qui est maintenue grâce à deux gâchettes 103, appartenant au mécanisme de verrouillage 102, qui viennent se loger dans deux logements 104 aménagés de part et d'autre du « nez » du module 40.

La pression sur le joint 100 en forme de « genouillère » (voir figure 33) a pour effet de faire grossir ce dernier sur tout son périmètre, répartissant une force suffisante sur celui-ci pour assurer une excellente étanchéité.

Différents matériaux peuvent être utilisés pour réaliser ce joint 100, par exemple le vitton, le kalrez, le chemraz.

Le joint 100 est armé par une armature 105 dont la rigidité est calculée pour répartir convenablement la pression du joint 100 sur tout le périmètre du « nez » du module 40.

Un logement en forme de coin 106 aménagé dans le joint 100 permet de bloquer l'objet plat 10 dans le module. Ce logement 106 joue le même rôle que le « coin » 86, décrit précédemment, solidaire de la porte 49.

Des formes particulières 111 et 112 sont réalisées dans le nez du module 40 pour permettre d'une part (forme 112) de réaliser une étanchéité vis-à-vis de l'extérieur du module 40 grâce à un joint 120 de forme oblongue, et d'autre part (forme 111) de recevoir un corps de porte 101 doté d'une forme complémentaire à (111) permettant de se prémunir des variations de forme du nez du module 40.

Le dispositif de verrouillage 102 est commandé et animé par un mécanisme complémentaire 107 solidaire de la contreporte d'une bride d'ouverture.

L'association des mécanismes 102 et 107 permet de déverrouiller la porte 49 du module 40 pour pouvoir libérer la porte du module. Dans la même action les mécanismes 102 et 107 sont solidarisés pour permettre de retirer la porte 49 du module 40.

Au moment de la fermeture du module 40 un palpeur solidaire du mécanisme 107 permet de reverrouiller la porte 49 sur son module 40 et de libérer les mécanismes 102 et 107 pour pouvoir retirer la bride.

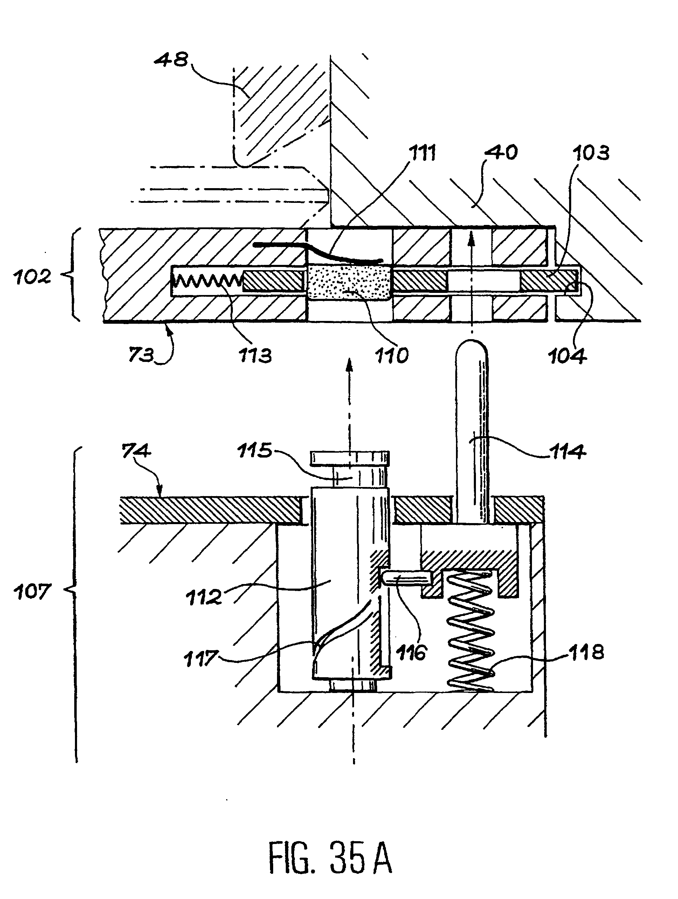

La figure 35A est une coupe du mécanisme 102 de verrouillage entre la porte 73 d'une alvéole et le mécanisme 107 du système d'accouplement de l'invention, et du mécanisme 107 complémentaire de celui installé dans la porte. La position du mecanisme représenté dans cette figure correspond à la position lorsque les deux mécanismes 102 et 107 sont désolidarisés.

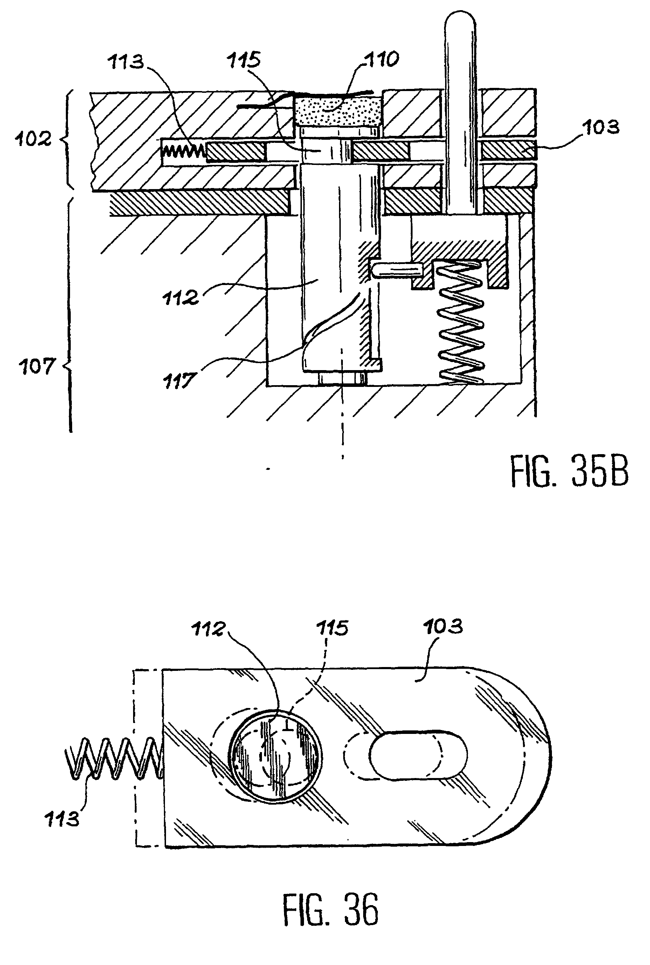

La figure 35B est une coupe du système de verrouillage lorsque la porte de l'alvéole est accouplée au mécanisme de la bride pour permettre l'escamotage de la porte de l'alvéole dans la bride.

La figure 36 représente les deux positions de la gâchette 103, en trait plein la position de verrouillage de la porte 73 et en trait pointillé la position de libération de la porte 73 qui correspond aussi à la position de verrouillage sur la porte 74.

Comme illustré sur ces figures 35 et 36 un exemple de mécanisme 102, permettant de verrouiller la porte 73 pour fermer l'alvéole correspondante grâce à deux gâchettes 103 qui viennent se loger dans deux logements 104 correspondants, est commandé et animé par un mécanisme complémentaire 107 solidaire de la porte 74 de la bride d'ouverture 70.

L'association des mécanismes 102 et 107 permet de déverrouiller la porte 73 fermant l'alvéole pour pouvoir libérer celle-ci. Dans la même action les mécanismes 102 et 107 sont solidarisés pour permettre de retirer la porte 73.

Au moment de la fermeture de l'alvéole un palpeur 114 solidaire du mécanisme 107 permet de reverrouiller la porte 73 sur l'alvéole et de libérer les mécanismes 102 et 107 pour pouvoir retirer la bride 70.

Une gâchette 103, qui est montée dans le corps de la porte, comporte deux ouvertures, une première apte à laisser passer le palpeur 114 solidaire du mécanisme 107, et une seconde dans laquelle vient se positionner un bouchon 110, qui est maintenu en place par un ressort 111, cette gâchette étant solidaire d'un ressort de rappel 113.

Le mécanisme 107 comprend un palpeur 114 monté sur un ressort 118, et une pièce mobile en rotation, ou percuteur, 112 comportant sur sa périphérie une gorge 117 en forme de came et sur sa surface supérieure un excentrique 115. Le palpeur 114 et le percuteur 112 sont montés en parallèle de manière à ce qu'un ergot 116 solidaire de la base du palpeur 114 vienne se positionner dans la gorge, un appui sur le palpeur 114 permettant une rotation du percuteur 112 d'un demi tour.

La gâchette 103, montée dans le corps de la porte 73, assure le verrouillage de la porte 73 pour fermer l'alvéole et assure la liaison de la porte 73 avec la porte 74 de la bride pour permettre de retirer la porte 73, et ainsi de pouvoir accéder à l'objet 10.

La gâchette 103 est maintenue en position de verrouillage grâce au bouchon 110 maintenu en place grâce au ressort 111.

Au moment de l'accostage la pièce 112 du mécanisme 107 vient percuter le bouchon 110 qui en reculant libère la gâchette 103 qui peut se retirer de sa position de verrouillage grâce au ressort 113.

Le palpeur 114 monté sur ressort 118 traverse le mécanisme 102 pour venir s'appuyer sur le corps du module 40. En reculant ce palpeur 114 entraîne en rotation le percuteur 112 grâce au système de came 116-117. Ce faisant, l'excentrique 115 pivote de 180° permettant à la gâchette 103 de se mettre en position déverrouillée et dans le même temps verrouille le percuteur 112 avec la gâchette 103, liant ainsi les mécanismes 102 et 107, et donc la porte 73 et la porte 74.

La tête de la pièce 112 est dotée d'une gorge excentrique 117 qui sous l'effet de la rotation de 1/2 tour induite par le recul du palpeur 114 va libérer la gâchette 103, qui tirée par le ressort 113 va se dégager du logement 104 déverrouillant ainsi la porté 73 de l'alvéole. Se faisant, la gâchette 103 va venir s'engager dans la gorge excentrique pour verrouiller la porte 73 sur le mécanisme 107 permettant ainsi l'escamotage de la porte. Cette situation est illustrée figure 35B.

Pour refermer une alvéole après un transfert d'objet 10 et pouvoir ainsi libérer l'alvéole de la bride pour accéder à d'autres alvéoles, le mécanisme interne de la bride ramène l'ensemble porte 73-porte 74 représenté sur la figure 35B dans la position d'accostage boîte-bride.

Le palpeur 114 vient à nouveau prendre appui sur le boîtier de l'alvéole, être repoussé, arrimant ainsi la pièce 112 d'un demi tour, dont la gorge excentrique va repousser la gâchette 103 en position de verrouillage de la porte 73. Dans cette position, il est possible de désolidariser la porte 73 de la porte 74, la pièce 112 étant libérée de la gâchette 103.

En simultanéité du retrait du mécanisme 107 le bouchon 110 repoussé par le ressort 111 va venir prendre la place de la pièce 112, verrouillant la gâchette 103 en position, dans la position où la porte 73 et la boîte 40 sont liées.

Lorsque la porte 74 ramène la porte 73 pour refermer l'alvéole, le palpeur 114 vient en contact avec la boîte de l'alvéole et recule.

Son mouvement de recul entraîne progressivement une rotation de 180° du percuteur 112, qui ramène la gâchette 103 en position de verrouillage grâce à la rotation associée de l'excentrique 115 du percuteur 112.

La porte 74 peut alors se retirer, le bouchon de blocage 110 vient remplacer le percuteur 112 pour maintenir la gâchette 103 en position de verrouillage.

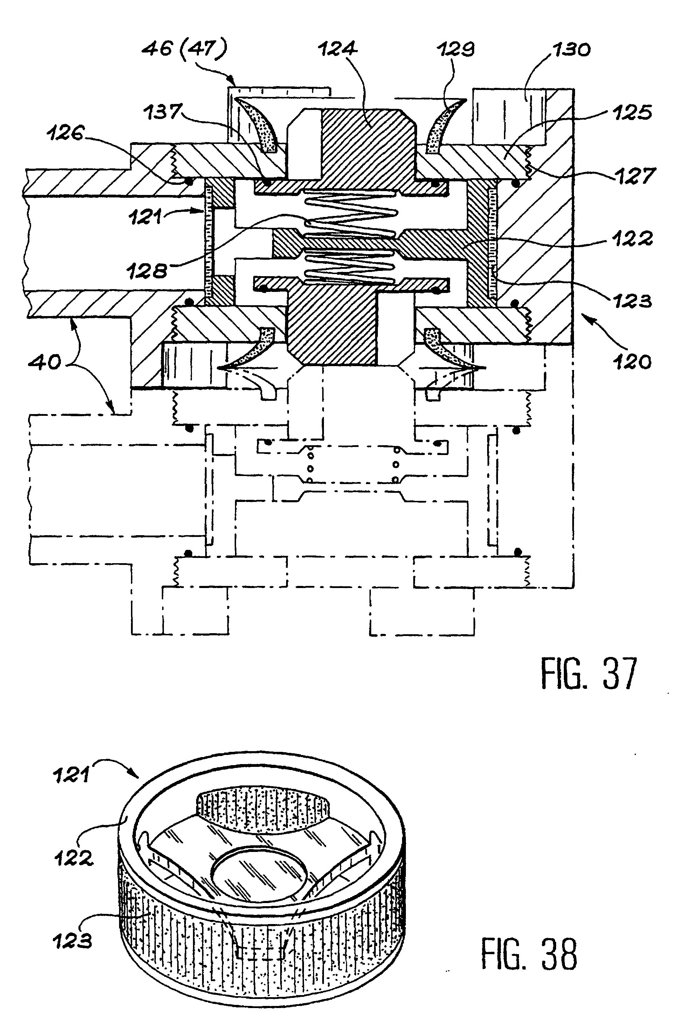

Dans une variante de réalisation, illustrée sur la figure 37, le connecteur auto-obturant 38, illustré sur la figure 21, est repris de façon à pouvoir être monté de part et d'autre de l'élément de cheminée et d'autre part pour intégrer une fonction de filtrage des particules qui pourraient être libérées lors de la connexion/déconnexion des modules 40.

Chaque élément de cheminée 46 ou 47 du module 40, comme illustré notamment sur la figure 14, peut recevoir un ou deux connecteurs 120 selon la place du module 40 dans un empilage 39, illustré par exemple sur la figure 13. Si le module 40 est le module terminal de l'empilage 39, il reçoit un seul connecteur 120, placé du côté extérieur par rapport à l'empilage. Dans le cas où l'empilage est composé d'un seul module 40, chaque élément de cheminée reçoit deux connecteurs 120 situés de part et d'autre de l'élément de cheminée 46 ou 47. La figure 37 représente une configuration de ce dernier type associée à un autre ensemble, comme illustré par exemple sur la figure 13.

L'élément de filtration peut être réalisé par une couronne centrale 121, illustrée figure 38, composée d'une couronne rigide 122, en polycarbone par exemple, sur laquelle est rapportée une membrane filtrante 123. Les formes de ces pièces sont aménagées pour permettre le passage du gaz à travers le connecteur et l'alimentation de l'intérieur du module 40 avec un gaz filtré (exempt de particules).

Les connecteurs 120 sont montés de part et d'autre de cet élément de filtration 121. Chaque connecteur 120 est composé d'un clapet à trois pans 124, guidé par un flasque 125 monté étanche grâce à un joint 126 sur l'élément de cheminée du module 40.

Ce flasque 125 est maintenu en pression par des formes 127, de type filetage par exemple. Le clapet 124 ferme l'orifice du connecteur 120 de façon étanche, lorsque celui-ci n'est pas connecté, grâce à la pression d'un ressort 128 sur un joint 137. Un joint à lèvres 129 permet d'assurer l'étanchéité entre les éléments de cheminée d'un ensemble 39.

Des formes complémentaires 130 sont réalisées de part et d'autre de l'élément de cheminée pour empêcher que le clapet 124 ne soit sollicité quand on pose le module 40 ou l'ensemble 39 sur un plan de travail, ce qui permet de garantir l'étanchéité de ceux-ci.

Lorsque deux modules 40 sont positionnés l'un au-dessus de l'autre, comme illustré sur la figure 37, les deux clapets 124 en correspondance sont repoussés, les joints 129 réalisant « une cuvette étanche » entre les clapets. Cette « cuvette » est purgée, au moment de la connexion, avant que les modules ne soient en position définitive. Le gaz peut passer d'un étage à l'autre grâce aux formes aménagées sur les clapets 124 et peut alimenter les modules 40 en gaz filtré.

Le dispositif de l'invention, tel que défini ci-dessus, permet de réaliser autour de l'objet plat 10 une "chaîne de propreté et de pureté" sans interruption entre le stockage, le transport et les échanges des objets plats 10 avec les machines de traitement (même avec les machines qui fonctionnent dans un environnement de vide).

Le dispositif est parfaitement étanche pendant les phases de transport. Pour cela chaque alvéole est fermée de façon étanche par une porte indépendante et toutes les alimentations en gaz sont obstruées.

Pendant le stockage d'objets dans les alvéoles, le dispositif est continuellement purgé par un gaz approprié (par exemple l'azote) pour diluer les contaminants volatils libérés. La distribution du gaz dans les différentes alvéoles est réalisée par la structure de "cheminée".

Ainsi le dispositif de l'invention correspond à un panier conventionnel de transport et de stockage de plaques de semi-conducteur transformé le plus légèrement possible tout en lui donnant deux fonctionnalités supplémentaires :
- La possibilité de confiner individuellement les objets plats dans un environnements "inerte". Les différentes enceintes sont raccordées entre elles par deux "cheminées" assurant l'alimentation et l'extraction du gaz d'inertage.
- La possibilité de réaliser des ensembles de quelques tailles standards (par exemple 1, 4, 7, 13) par association rigide et fixe de modules de base grâce au dispositif d'assemblage.

Ces ensembles et/ou ces modules de bases sont positionnés les uns par rapport aux autres grâce à un système de repères. Dans le cas où les ensembles sont réalisés à partir des modules de base, comme représenté sur la figure 11, l'étanchéité entre les différents éléments de la "cheminée" est assurée par des joints maintenus en pression grâce au système d'assemblage. Il est possible d'associer et de dissocier ces différents ensembles manuellement ou automatiquement en vue de réaliser la flexibilité nécessaire pour optimiser au cas par cas l'utilisation des machines.

Le raccordement entre ces ensembles se fait en respectant le pas entre les positions des objets dans les enceintes.

Le système d'assemblage/désassemblage, qui assure une liaison rigide entre les ensembles, peut être réalisé manuellement ou automatiquement.

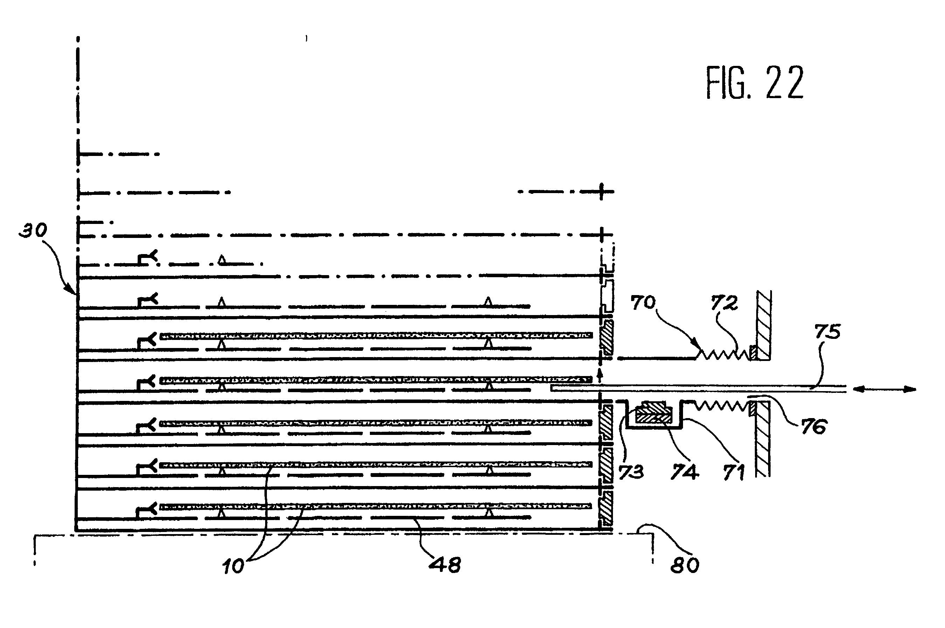

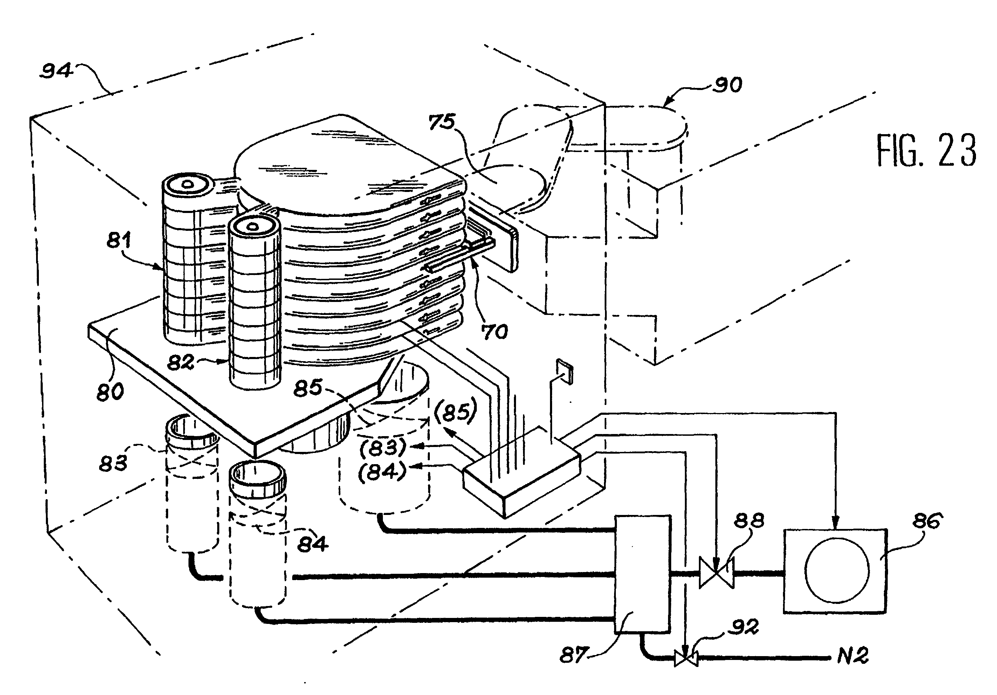

Lors de l'interfaçage avec les machines de traitement, la cassette est positionnée sur un plateau 80 solidaire de la machine et une bride spéciale 70 illustrée sur les figures 22 et 23 permet d'effectuer la connexion étanche avec les alvéoles.

Pour la mise en oeuvre de cette bride 70 on positionne sur le plateau 80 le dispositif de l'invention de telle sorte que chaque alvéole ou chaque module puisse être mis en communication avec la machine de traitement considéré par l'intermédiaire de la bride 70 pour former un tunnel étanche 76. Le plateau 80 est monté sur un indexeur de façon à adresser les différentes alvéoles. Une fois positionnée, la bride 70 assure la mise en communication d'une alvéole avec la machine afin qu'un robot 90 dont est dotée ladite machine puisse effectuer un transfert d'un objet 10 dans un sens ou dans l'autre. On utilise alors cette bride 70, qui comporte notamment un mors mobile 71 fermé par une porte 74 permettant de fermer de façon étanche la machine et un soufflet 72, pour réaliser une liaison étanche entre la machine et l'alvéole à ouvrir.

Le mors mobile 71 est raccordé à la partie fixe de la bride par le soufflet 72 pour amener la translation et garantir l'étanchéité avec la machine.

Dans le cas du raccordement des équipements "vide" ce soufflet est métallique.

La bride de raccordement comporte deux systèmes d'oreillettes qui se logent de chaque côté du module. Elles sont mobiles transversalement de façon à ce qu'une butée vienne se loger dans le module pour le maintenir en position lorsque le mors mobile avance sur le module. Le système d'oreillette comporte, à l'intérieur, un mécanisme qui permet d'actionner les baïonnettes qui sont dans le module pour manoeuvrer la porte.

La bride 70 est dotée d'un mécanisme de translation pour permettre l'avance et le recul du mors mobile 71, d'un autre mécanisme capable de venir engager deux butées de part et d'autre de l'alvéole pour que le mors mobile 71 puisse venir exercer une pression sur l'alvéole pour assurer l'étanchéité sans dépositionner le dispositif de l'invention.

Un autre mécanisme permet d'actionner les baïonnettes pour assurer le transfert de la porte 73 de l'alvéole sur la porte 74 du mors mobile 71 et libérer cette porte pour permettre son escamotage dans le mors mobile.

Enfin le mors mobile 71 est doté d'un mécanisme permettant l'escamotage des deux portes 73 et 74.

Avantageusement des systèmes de "vision" équipent le mors mobile 71 pour contrôler avant l'accostage la position de l'alvéole à ouvrir.

D'autres capteurs permettent de contrôler la position du doigt du robot, ou de l'objet au moment de la prise ou de la dépose d'un objet 10 de façon à réaliser cette opération sans générer de particules (pas de frottement). Une barrette de photodiodes ou CDD peut permettre de lire à la volée (au passage) l'identification de l'objet 10 inscrite en général en périphérie de celui-ci.

Ainsi, contrairement aux dispositifs de l'art antérieur, dans lesquels la boîte est poussée contre le système d'ouverture et le plateau doit effectuer un mouvement transversal en plus d'un mouvement de haut en bas, dans l'invention, la cassette est fixe et c'est le mors mobile de la bride de raccordement qui s'aboute à la porte d'une alvéole.

Les butées solidaire d'un mécanisme d'oreillettes latérales viennent se positionner de part et d'autre de chaque alvéole, permettent un maintien en position de la cassette lors de la connexion de l'alvéole considérée avec le mors mobile de la bride en maintenant une pression telle que l'étanchéité de la connexion soit réalisée.

Cette bride 70 est dotée de moyens permettant d'ouvrir la porte de l'alvéole 73 et la porte 74 fermant la machine afin de réaliser un tunnel de communication étanche dans lequel le robot 75 de la machine peut réaliser le transfert de l'objet.

Ce dispositif d'interfaçage comprenant une bride d'adaptation dotée d'un mors mobile 71 est nécessaire pour assurer la continuité de la protection de l'objet 10 au moment de l'échange. Cette bride 70 est équipée des moyens qui permettent à la fois d'ouvrir et de fermer les portes 73 et 74 qui ferment d'une part les alvéoles contenant les objets plats et celles qui assure la fermeture côté "équipement".

Ce dispositif d'interfaçage permet d'assurer le transfert d'objets plats 10, par exemple des plaques de semi-conducteur, entre le dispositif de transport de l'invention, étanche et éventuellement en légère surpression, à porte latérale, contenant un nombre limité d'alvéoles contenant chacune un objet plat, et une machine de traitement où ces objets subiront des traitements particuliers (insolation, dépôt de couches, gravure de ces couches...) en utilisant le robot (de type "pick and place") interne de la machine de procédé.

Ce dispositif est rapporté sur la machine de telle façon que le doigt terminal 75 ("end effector") de son robot interne 90 puisse passer au travers de la bride du dispositif d'interfaçage pour aller chercher ou déposer les objets 10 dans les alvéoles de la cassette lorsque celle-ci est connectée. Le dispositif de l'invention est également positionné par rapport à la machine pour que cette opération soit possible grâce à l'utilisation d'un plateau 80.

Lorsque la connexion n'est pas réalisée, la bride d'interfaçage assure une fermeture étanche de la partie interne de la machine par rapport à l'extérieur, ou une fermeture au vide si la partie interne de la. machine est au vide. Dans cette situation, le dispositif de l'invention est libéré pour réaliser son chargement ou son déchargement de la machine, par remplacement ou indexation. C'est également dans cette position qu'on peut indexer séquentiellement les différentes alvéoles.

Le dispositif de l'invention est monté sur un plateau 80 solidaire d'un indexeur qui adresse séquentiellement les différentes alvéoles lorsque le mors mobile est rétracté.

Ainsi, afin de réaliser la connexion du dispositif de l'invention à la machine de traitement doté d'un dispositif d'interfaçage, il est nécessaire que le positionnement du dispositif de l'invention par rapport à la machine et son robot interne soit réalisé avec des tolérances adéquates. Ces conditions initiales étant satisfaites, pour obtenir une connexion, le dispositif d'interfaçage solidaire de la machine de traitement réalise, plus précisément, les étapes suivantes :
- positionnement précis du dispositif de l'invention sur le plateau de la machine ;
- positionnement précis d'au moins une alvéole en face du mors mobile 71 de la bride 70 ;
- raccordement étanche entre au moins une alvéole du dispositif de l'invention avec la machine par déplacement du mors mobile 71 de la bride 70 grâce à un mécanisme de translation solidaire de la bride 70 ;
- purge du volume mort entre la porte 73 de l'alvéole et la porte 74 du mors mobile 71 ;
- mise en contact de la porte 73 de l'alvéole sur la porte 74 du mors mobile 71, en actionnant les baïonnettes associées à l'alvéole par un mécanisme solidaire de la partie fixe de la bride. L'action sur ces baïonnettes permet aussi de solidariser les deux portes 73 et 74 ;
- ouverture simultanée des deux portes 73 et 74 ainsi solidarisées pour emprisonner les contaminations à l'interface. Cet escamotage, réalisé par un mécanisme solidaire du mors mobile 71 des deux portes à l'intérieur du mors mobile, libère un espace suffisant au passage du doigt 75 du robot interne 90 de la machine pour prendre ou déposer un objet plat 10 dans l'alvéole (par exemple une plaque de silicium).
- transfert de l'objet plat 10 par le robot 90 ;
- isolation sur le plan contamination de l'alvéole et de la machine : on réalise d'un flux de gaz approprié dans le mors mobile 71 afin d'isoler sur le plan contamination l'intérieur de l'enceinte par rapport à la machine pour éviter la contamination des alvéoles au moment du transfert de l'objet plat ; toutefois dans le cas des équipements "vide", il n'y a pas d'injection de gaz mais liaison au circuit de vide ;
- fermeture simultanée par le mécanisme dans la bride des deux portes 73 et 74 maintenues en contact. Une fois la position atteinte, la porte 74 du mors mobile 71 ferme de façon étanche la machine, alors que la porte 73 de l'alvéole ne ferme pas l'alvéole de façon étanche ;
- reconditionnement de l'atmosphère de l'alvéole avant fermeture : dans cette position on reconditionne la pureté dans l'enveloppe en injectant un gaz approprié ; toutefois on ne réalise pas cette opération pour les équipements "vide" ;
- désolidarisation des deux portes 73 et 74 par action du mécanisme sur la bride, sur les baïonnettes de la porte 73 de l'alvéole et recul de la porte de l'alvéole jusqu'à fermer de façon étanche l'alvéole ;
- retrait du mors mobile 71 par action du mécanisme de transfert solidaire de la bride 70 ;
- possibilité alors d'indexer pour ouvrir une autre alvéole ou bien de retirer le dispositif de l'invention de la machine.

On peut avoir, dans une variante de réalisation, plusieurs dispositifs interface (bride 70 + mors 71) disposés en parallèle qui peuvent fonctionner simultanément pour réaliser ainsi plusieurs "tunnels" entre plusieurs alvéoles et la machine de traitement.

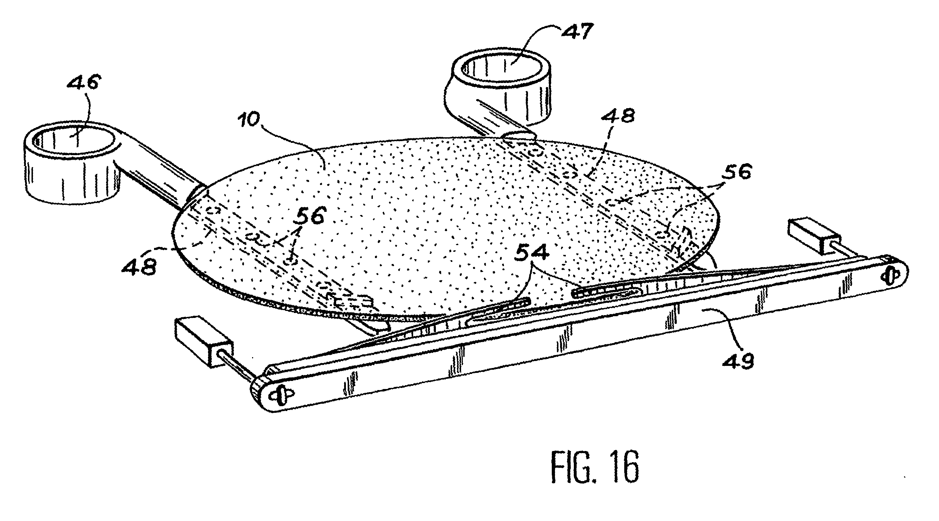

Dans le dispositif selon l'invention un objet 10 est maintenu à l'intérieur d'une l'alvéole sans toucher les surfaces internes supérieure et inférieure de l'alvéole. Ainsi, le flux d'air formé par le diffuseur des figures 16, 19 et 20 peut entourer complètement les deux faces de cet objet 10 et assurer ainsi son balayage aéraulique et garantir un renouvellement parfait de l'atmosphère environnant l'objet.

L'espace entre cet objet 10 et les surfaces supérieure et inférieure du volume interne de l'alvéole doit être suffisant pour que le flux puisse être quasiment laminaire (avec la face supérieure) et pour qu'un doigt terminal 75 d'un robot 90 puisse venir en dessous de cet objet pour procéder à la saisie de ce dernier. Un robot 90 du type "pick and place" convient pour ce type d'opérations et est compatible avec le dispositif selon l'invention.

On obtient ainsi un dispositif étanche confinant l'objet 10 dans un environnement adapté à son traitement ou à sa fabrication.

Il est également possible de faire régner à l'intérieur du dispositif des pressions différentes, telles qu'une légère surpression pour assurer une meilleure protection pendant les transports et le stockage de l'objet plat.

L'invention permet de garder les mêmes fonctionnalités d'interfaçage avec les machines de traitement que les paniers de transport classiquement utilisés.

Le dispositif de l'invention vient se placer en lieu et place du panier traditionnel sur l'équipement de procédé. Le principe et les moyens de l'échange des objets plats entre le panier traditionnel et la machine de traitement sont conservés.

Pour les machines de traitement dont les échanges de plaques doivent se faire sous vide, le dispositif de l'invention est introduit dans un sas comme un panier traditionnel.

Pour satisfaire les conditions d'échange entre les objets dans le sas et le coeur de la machine, on amène la pression dans le sas au même niveau que celui dans la machine.

Dans le dispositif de l'invention on réalise ainsi le vide à l'intérieur des alvéoles par les deux cheminées en simultanéité avec la réalisation du vide dans le sas.

Sur la figure 23, est représenté le dispositif de l'invention disposé sur un plateau mobile 80 ayant un mouvement vertical. Ce plateau 80 portant le dispositif de l'invention est placé dans une position particulière permettant la connexion des cheminées 81 et 82. Les enceintes sont vidées à travers les cheminées 81 et 82, avec les deux vannes 83 et 84 commandées par exemple électriquement. Le sas 94 est relié à une vanne 85. ces vannes 83, 84 et 85 sont connectées à au moins une pompe à vide 86 par l'intermédiaire d'un circuit d'asservissement de pression 87 et d'une vanne 88 de manière à pouvoir effectuer le vide simultanément dans les alvéoles et dans le sas. Des capteurs de pression sont disposés à cet effet dans les alvéoles et dans le sas 90. Une vanne 92 permet également une arrivée d'azote dans le circuit 87.

On réalise simultanément le vide dans les différentes alvéoles du dispositif et dans le sas, afin de pouvoir interfacer les machines dont les procédés sont réalisés dans le vide sans rupture de la chaîne de propreté et surtout sans nécessité d'opérations supplémentaires pour sortir les objets des alvéoles et les réintroduire dans le sas de la machine. On a ainsi réalisé le même niveau de vide dans les différentes alvéoles, dans le sas et dans la machine de procédé. La procédure de transfert d'objet peut alors être réalisée selon le procédé de l'invention.

La connexion du dispositif de l'invention, telle que décrite précédemment, peut alors avoir lieu de manière à permettre la prise ou la dépose d'un objet plat 10.

Un système de régulation réalise la mise au vide sans écart de pression préjudiciable pour les alvéoles. Lorsque le procédé est terminé, avant de ressortir la cassette du sas, le même système assure la remontée à la pression atmosphérique en injectant de l'azote simultanément et sans déséquilibre de pression entre le sas et les alvéoles. On remonte ainsi à la pression atmosphérique en simultanéité dans le sas et dans les alvéoles.

Ainsi concernant l'utilisation de machines mettant en oeuvre un procédé effectué dans le vide, contrairement aux cassettes utilisées dans l'art antérieur, dans lesquelles les objets sont nécessairement transférés dans un sas à vide avant leur arrivée dans la machine, la cassette de l'invention est introduite directement dans le sas à vide.

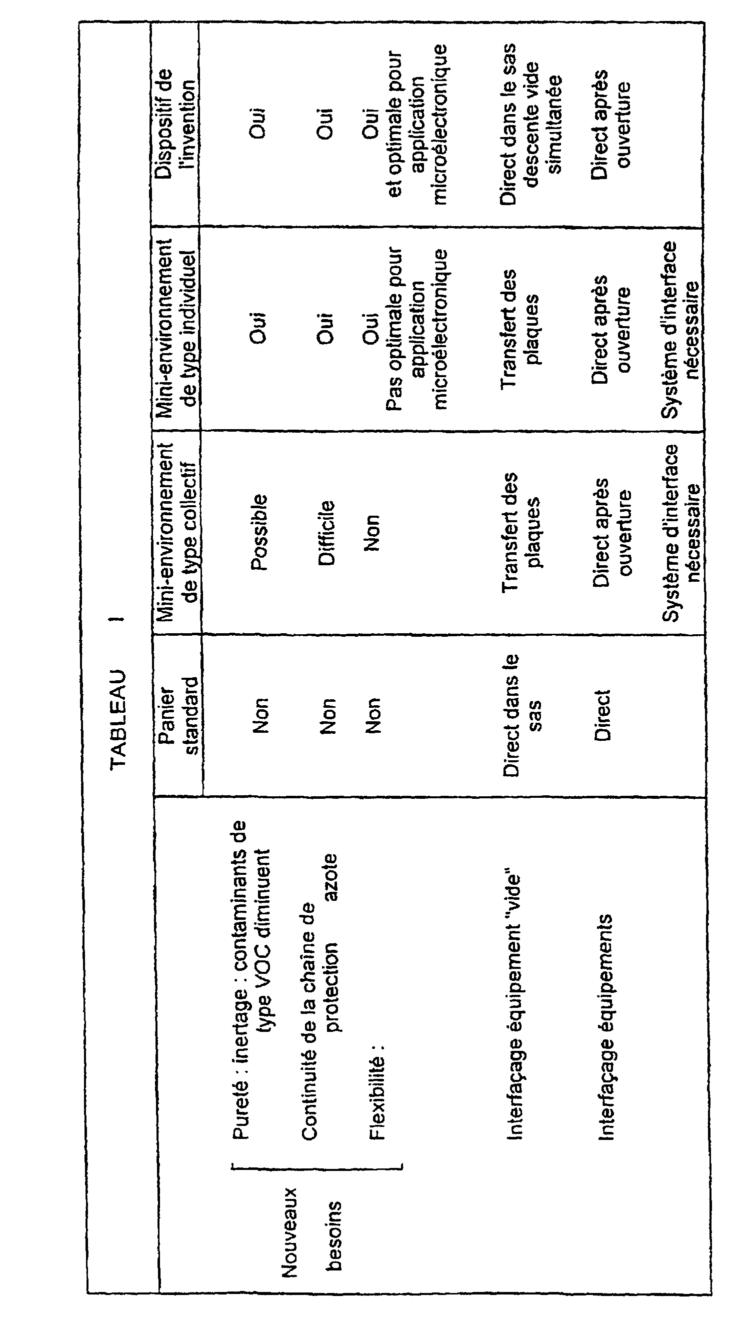

### REFERENCES

[1] EP-A-0 582 016 (International Business Machines Corporation)
[2] EP-A-0 582 018 (International Business Machines Corporation)
[3] FR-A-2 697 000 (Commissariat à l'Energie Atomique)
[4] FR-A-2 697 003 (Commissariat à l'Energie Atomique)
[5] FR-A-2 697 004 (Commissariat à l'Energie Atomique)

## Revendications

1. Dispositif de transport collectif (39) d'objets plats (10) confinés individuellement dans une atmosphère déterminée comportant un empilement de plusieurs modules (40) de forme plate chaque module comprenant une alvéole plate de faible épaisseur débouchant sur une face latérale dudit module (40), chaque module (40) étant apte à recevoir un seul objet plat (10) et à être fermé par une porte indépendante (33), **caractérisé en ce que** chaque module (40) comprend au moins trois plots de positionnement (28, 60) situés sur les deux faces de celui-ci pour permettre un positionnement deb modules les uns par rapport aux autres lors de leur empilage et des moyens intégrés d'assemblage (51, 52) avec le module inférieur et/ou supérieur, ces moyens d'assemblage (51, 52) étant complémentaires, de façon à ce que le moyen (51) d'un module soit verrouillé par le moyen (52) du module placé immédiatement dessous ou dessus.

2. Dispositif selon la revendication 1, dans lequel chaque module (40) comporte au moins une zone transparente en regard de l'objet plat (10).

3. Dispositif selon la revendication 1, dans lequel les moyens d'assemblage (51, 52) et/ou des moyens de positionnement (23, 60) réalisent la connexion électrique de masse pour permettre l'écoulement des charges électrostatiques accumulées sur les objets plats (10) et dans les modules (40) vers un point de masse.

4. Dispositif selon la revendication 1, dans lequel chaque module (40) comporte, de chaque côté, au moins une oreillette supérieure (92, 93, 94) 95, 98) et au moins une oreillette inférieure (91), ces oreillettes étant réalisées pour permettre l'empilage des modules (40) et amener en correspondance deux oreillettes inférieures ou supérieures d'un module (40) avec une oreillette supérieure ou inférieure complémentaire d'un module voisin ; un mécanisme logé dans les oreillettes inférieures (91) permettant d'une part de venir verrouiller les modules (40) entre eux et d'autre part, de venir plaquer les modules (40) les uns sur les autres, lors de l'empilage de ceux-ci.

5. Dispositif selon la revendication 1, comportant une poignée de manipulation (55, 61) munie des mêmes dispositifs d'assemblage (51, 52) que ceux des modules (40) de façon à être assemblée sur la surface supérieure dudit dispositif (39).

6. Dispositif selon la revendication 1 purgeable à partir d'un plateau (80) sur lequel est installé le dispositif, ce plateau étant doté de connecteurs (38) d'amenée et de retour de gaz, situés en partie arrière, à l'opposé de la face d'accès des objets plats, dans lequel chaque module élémentaire (40) comporte dans sa partie arrière deux éléments de cheminées (46, 47), plans, situés horizontalement, en communication avec l'intérieur du module, assurant respectivement l'amenée et le retour du gaz dans celui-ci, chaque élément de cheminée étant muni sur sa face inférieure et supérieure d'un joint (44) pour réaliser une étanchéité avec les éléments de cheminées des autres modules (40) du dispositif, l'étanchéité étant obtenue par action conjuguée du joint et du système d'assemblage (51, 52).

7. Dispositif selon la revendication 6 dans lequel les éléments de cheminée des modules (40) sont terminés par des connecteurs auto-obturants (38).

8. Dispositif selon la revendication 7, dans lequel chaque connecteur auto-obturant (38) comprend un élément de filtration (121), et un clapet (124), guidé par un flasque (125) monté étanche grâce à un premier joint (126) sur chaque élément de cheminée du module (40), ce flasque (125) étant maintenu en pression par des formes (127), le clapet (124) fermant l'orifice du connecteur de façon étanche, lorsque celui n'est pas connecté, grâce à la pression d'un ressort (128) sur un second joint (137), un joint à lèvres (129) permettant d'assurer l'étanchéité entre les éléments de cheminée (46, 47) de deux modules (40) voisins.

9. Dispositif selon la revendication 6, dans lequel chaque module (40) comprend des moyens internes de purge, réalisés par deux tubes (48) perforés (56) présentant une extrémité borgne, et une extrémité raccordée aux éléments de cheminées.

10. Dispositif selon la revendication 9, dans lequel les éléments internes de purge (48) servent aussi d'éléments de sustentation de l'objet.

11. Dispositif selon la revendication 1, qui est étanche et dans lequel chaque module (40) est doté d'une porte indépendante munie d'un joint genouillère (100) déformable sous l'action d'une pression exercée sur le corps de la porte (101) par un mécanisme de verrouillage (102).

12. Dispositif selon la revendication 11, dans lequel le corps de la porte (101) des modules (40) est doté d'une forme (111) réalisant un emboîtement avec une forme complémentaire (112) réalisée à l'intérieur du nez du module.

13. Dispositif selon la revendication 1, dans lequel la fonction blocage de l'objet plat (10) dans chaque module (40) est assurée par un système de positionnement rigide (86) en forme de « coin » solidaire de la porte (49), associée à deux butées ressorts (85) et deux éléments (87) en forme de fourchette disposés à l'arrière du module (40) empêchant l'objet plat (10) de bouger dans le module (40).

14. Procédé de transfert d'un objet plat (10) d'un module (40) du dispositif (39), selon l'une quelconque des revendications précédentes, dans une machine de traitement, **caractérisé en ce que**, ledit dispositif étant positionné sur un plateau (80) monté sur un indexeur vertical,
- on adresse un module (40) donné du dispositif (39), après un mouvement vertical de ce plateau (80),
- on met en communication ce module (40) choisi avec la machine de traitement considérée par l'intermédiaire d'une bride rétractable (70), qui comporte un mors mobile (71) fermé par une porte (74), permettant de fermer de façon étanche la machine en position rétractée, un soufflet (72) et des moyens de translation, pour pouvoir venir aboucher le mors mobile (71) sur le module (40) et réaliser une liaison étanche entre la machine et ce module (40), la porte (73) du module (40) et la porte (74) du mors mobile étant associées et escamotées à l'intérieur du mors mobile pour former un tunnel étanche entre le module (40) et la machine,
- on effectue le transfert de l'objet (10) à l'aide d'un robot (90), dont est dotée cette machine, dans un sens ou dans l'autre, selon un mouvement de translation.

15. Procédé selon la revendication 14, dans lequel le transfert de l'objet se fait à pression atmosphérique et se déroule selon les étapes suivantes :
a)positionnement du dispositif de l'invention sur un plateau (80) de la machine en position de chargement ;
b)ajustement de la pression à l'intérieur du dispositif sur la pression à l'intérieur de la machine par l'intermédiaire des cheminées et des amenées de gaz sur le plateau (80) ;
c)indexation verticale du dispositif pour amener le module (40) contenant l'objet à transférer en face du mors mobile (71) de la bride (70) ;
d)raccordement étanche entre ce module (40) et la machine, par déplacement du mors mobile (71) de la bride (70) grâce à un mécanisme de translation solidaire de la bride (70) ;
e)purge du volume mort entre la porte (73) du module (40) et la porte (74) du mors mobile (71) ;
f)liaison de la porte (73) du module (40) sur la porte (74) du mors mobile (71) grâce à un mécanisme appartenant à la bride (70) ;
g)ouverture simultanée des deux portes (73, 74) ainsi solidarisées pour emprisonner les contaminations à l'interface et escamottage de ces deux portes liées dans un espace prévu à l'intérieur du mors mobile (71);
h)isolation sur le plan contamination de l'alvéole du module (40) et de la machine ;
i)transfert de l'objet plat (10) par le robot (90) à travers le tunnel étanche ;
j)fermeture simultanée par le mécanisme dans la bride des deux portes (73, 74) maintenues en contact ;
k)désolidarisation des deux portes (73, 74) par action du mécanisme de la bride, qui réalise aussi le verrouillage de la porte (73) du module (40) et sa fermeture étanche ;
l)retrait du mors mobile (71) par action du mécanisme de transfert solidaire de la bride (70).
m)optionnellement retour à l'étape c pour transférer un autre objet contenu dans un autre module ou étape suivante si l'opération de transfert est terminée ;
n)ramener le dispositif à sa position de chargement ;
o)reconditionnement de l'atmosphère du dispositif par un cycle de purge.

16. Procédé selon la revendication 14, dans lequel on réalise un contrôle de la position du module (40) à ouvrir avant l'accostage grâce à des systèmes de "vision" équipant le mors mobile (71).

17. Procédé selon la revendication 14, dans lequel on contrôle la position du doigt du robot, ou de l'objet au moment de son passage à travers le mors mobile (71) grâce à des capteurs, de façon à réaliser l'opération de prise ou de dépose de l'objet dans l'alvéole sans générer de frottement ;

18. Procédé selon la revendication 14, dans lequel on lit à la volée l'identification de l'objet (10) inscrite sur celui-ci, grâce à un capteur de vision installé dans la bride (70).

19. Procédé selon la revendication 14, dans lequel le transfert se fait sous vide, la bride (70) étant montée à l'intérieur d'un SAS de transfert (94) et le dispositif étant placé sur le plateau (80) de l'indexeur appartenant au SAS, en position de chargement, ce procédé se déroulant selon les étapes suivantes :
a')positionnement du dispositif sur un plateau (80) de la machine en position de chargement ;
b')mise au vide du dispositif, réalisée en simultanéité avec la mise au vide du SAS ;
c')indexation verticale du dispositif pour amener le module (40) contenant l'objet à transférer en face du mors mobile (71) de la bride (70) ;
d')raccordement étanche entre ce module (40) et la machine par déplacement du mors mobile (71) de la bride (70) grâce à un mécanisme de translation solidaire de la bride (70) ;
e')purge du volume mort entre la porte (73) du module (40) et la porte (74) du mors mobile (71) ;
f') liaison de la porte (73) du module (40) sur la porte (74) du mors mobile (71) grâce à un mécanisme appartenant à la bride (70) ;
g')ouverture simultanée des deux portes (73, 74) ainsi solidarisées pour emprisonner les contaminations à l'interface et escamottage de ces deux portes liées dans un espace prévu à l'intérieur du mors mobile (71);
h')transfert de l'objet plat (10) par le robot (90) à travers le tunnel étanche ;
i')fermeture simultanée par le mécanisme dans la bride des deux portes (73, 74) maintenues en contact ;
j')désolidarisation des deux portes (73, 74) par action. du mécanisme de la bride, qui réalise aussi le verrouillage de la porte (73) du module (40) et sa fermeture étanche ;
k')retrait du mors mobile (71) par action du mécanisme de transfert solidaire de la bride (70).
l')optionnellement retour à l'étape c pour transférer un autre objet contenu dans un autre module ou étape suivante si l'opération de transfert est terminée ;
m')ramener le dispositif à sa position de chargement ;
n')remise à la pression atmosphérique dans le dispositif, réalisée selon le même principe que la descente au vide, le système de régulation assurant alors la remontée simultanée de la pression dans le SAS et dans le dispositif en contrôlant le débit d'azote injecté dans le SAS et dans le dispositif par l'intermédiaire des cheminées.

## Patentansprüche

1. Kollektivtransportvorrichtung (39) flacher Gegenstände (10), einzeln eingeschlossen in eine bestimmte Atmosphäre, einen Stapel von mehreren flach geformten Modulen (40) umfassend, wobei jeder Modul eine flache Zelle von geringer Dicke aufweist, die an einer Seitenfläche des genannten Moduls (40) mündet, jeder Modul (40) einen einzigen flachen Gegenstand (10) aufnehmen kann und mittels einer unabhängigen Tür (33) verschlossen werden kann,
**dadurch gekennzeichnet,**
**dass** jeder Modul (40) wenigstens drei Positionierungseinrichtungen (28, 60) umfasst, die sich auf seinen beiden Seiten befinden, um eine gegenseitige Positionierung der Module bei ihrer Stapelung zu ermöglichen, sowie integrierte Einrichtungen (51, 52) für den Zusammenbau mit dem unteren und/oder oberen Modul, wobei diese Zusammenbaueinrichtungen (51, 52) in der Weise komplementär sind, dass die Einrichtung (51) eines Moduls verriegelt wird durch die Einrichtung (52) des unmittelbar darunter oder darüber befindlichen Moduls.

2. Vorrichtung nach Anspruch 1, bei der jeder Modul (40) wenigstens eine dem flachen Gegenstand gegenüberstehende transparente Zone umfasst.

3. Vorrichtung nach Anspruch 1, bei der die Zusammenbaueinrichtungen (51, 52) und/oder Positionierungseinrichtungen (23, 60) die elektrische Masseverbindung herstellen, um das Abfließen der in den flachen Gegenständen (10) und den Modulen (40) gespeicherten elektrostatischen Aufladungen zu einem Erdungs- bzw. Massepunkt zu ermöglichen.

4. Vorrichtung nach Anspruch 1, bei der jeder Modul (40) auf jeder Seite wenigstens eine obere Öse (92, 93, 94, 95, 98) und wenigstens eine untere Öse (91) umfasst, wobei diese Ösen realisiert wurden, um das Stapeln der Module (40) zu ermöglichen und zwei untere oder obere Ösen eines Moduls (40) in Übereinstimmung zu bringen mit einer komplementären oberen oder unteren Öse eines benachbarten Moduls; ein in den unteren Ösen (91) sitzender Mechanismus ermöglicht, einerseits die Module (40) miteinander zu verriegeln und andererseits die Module (40) bei ihrer Stapelung gegeneinander zu pressen.

5. Vorrichtung nach Anspruch 1, einen Handgriff (55, 61) umfassend, ausgestattet mit den gleichen Zusammenbaueinrichtungen (51, 52) wie die Module (40), so dass er an der Oberseite der genannten Vorrichtung (39) festgemacht werden kann.

6. Vorrichtung nach Anspruch 1, die auf einer Platte (80) entlüftet werden kann, auf der die Vorrichtung festgemacht wird, wobei diese Platte Verbindungseinrichtungen (38) für das Zufließen und Abfließen von Gas umfasst, die sich im hinteren, der Zugangsseite der flachen Gegenstände (10) entgegengesetzten Teil befinden, bei der jeder Elementarmodul (40) in seinem hinteren Teil zwei horizontal ausgerichtete ebene Kaminelemente (46, 47) umfasst, die jeweils für das Zufließen und das Abfließen des Gases mit der Modul-Innenseite kommunizieren, wobei jedes Kaminelement an seiner Unter- und Oberseite mit einem Dichtring (44) ausgestattet ist, um Dichtheit herzustellen mit den Kaminelementen der anderen Module (40) der Vorrichtung, wobei die Dichtheit durch das Zusammenwirken des Dichtrings und des Zusammenbausystems (51, 52) hergestellt wird.

7. Vorrichtung nach Anspruch 6, bei der die Kaminelemente der Module (40) mit Selbstverschluss-Verbindungseinrichtungen (38) enden.

8. Vorrichtung nach Anspruch 7, bei der jede Selbstverschluss-Verbindungseinrichtung (38) jedes Kaminelements des Moduls (40) ein Filterelement (121) umfasst und eine Rückschlagklappe (124), geführt durch einen Flansch (125), abdichtend montiert dank eines ersten Dichtring (126), wobei dieser Flansch (125) durch Formen (127) unter Druck gehalten wird, und das Rückschlagventil (124) die Öffnung der Verbindungseinrichtung, wenn diese nicht angeschlossen ist, dicht verschließt dank des Drucks einer Feder (128) auf einen zweiten Dichtring (137), wobei eine Lippendichtung (129) ermöglicht, die Dichtheit zwischen den Kaminelementen (46, 47) von zwei benachbarten Modulen (40) herzustellen.

9. Vorrichtung nach Anspruch 6, bei der jeder Modul (40) inteme Entlüftungseinrichtungen umfasst, realisiert in Form von zwei perforierten (56) Rohren (48), die an einem Ende verschlossen sind und mit ihrem anderen Ende an die Kaminelemente angeschlossen sind.

10. Vorrichtung nach Anspruch 9, bei der die internen Entlüftungselemente (48) auch dazu dienen, den Gegenstand in der Schwebe zu halten.

11. Vorrichtung nach Anspruch 1, die dicht ist und in der jeder Modul (40) mit einer unabhängigen Tür versehen ist, die auf der Innenseite mit einem verformbaren, den Gegenstand nach Art eines Knieschützers schützenden Element (100) ausgestattet ist, das unter der Wirkung eines Drucks nachgibt, der auf den Körper der Tür (101) durch einen Verriegelungsmechanismus (102) ausgeübt wird.

12. Vorrichtung nach Anspruch 11, bei dem der Körper der Tür (101) der Module (40) eine Form (111) aufweist, die beim Schließen der Tür zusammenwirkt mit einer komplementären Form (112), realisiert im Innern der Vorderseite des Moduls.

13. Vorrichtung nach Anspruch 1, bei der die Funktion des Blockierens jedes flachen Gegenstands (10) in jedem Modul (40) gewährleistet wird durch ein starres Positionierungselement (86), das fest mit der Tür (49) verbunden ist und dem zwei Federanschläge (85) und zwei gabelförmige Elemente (87) zugeordnet sind, die sich hinten im Modul (40) befinden, so dass der flache Gegenstand (10) sich in dem Modul (40) nicht bewegen kann.

14. Verfahren zum Transport eines flachen Gegenstands (10) eines Moduls (40) der Vorrichtung (39) nach einem der vorangehenden Ansprüche in einem Behandlungsapparat,
**dadurch gekennzeichnet,** wobei die genannte Vorrichtung auf einer Platte (80) positioniert wird, die auf eine vertikale Indexierungseinrichtung montiert ist,
- dass man einen bestimmten Modul (40) der Vorrichtung (39) nach einer Vertikalbewegung dieser Platte (80) adressiert,
- man diesen gewählten Modul (40) mit dem Behandlungsapparat in Verbindung bringt mittels eines einschiebbaren bzw. zurückziehbaren Flansches (70), mit einer beweglichen Backe (71), verschlossen durch eine Tür (74), die ermöglicht, den Apparat in der zurückgezogenen Stellung dicht zu verschließen, einem Faltenbalg (72) und Querverschiebungseinrichtungen, um die bewegliche Backe mit dem Modul (40) zu verbinden und zwischen dem Apparat und diesem Modul (40) eine dichte Verbindung herzustellen, wobei die Tür (73) des Moduls (40) und die Tür (74) der beweglichen Backe vereinigt sind und ins Innere der beweglichen Backe versenkt sind, um zwischen dem Modul (40) und dem Apparat einen dichten Tunnel zu bilden,
- man den Transport des Gegenstands (10) in die eine oder die andere Richtung als Parallelverschiebung mit Hilfe eines Roboters (90) ausführt, mit dem dieser Apparat ausgerüstet ist.

15. Verfahren nach Anspruch 14, bei dem der Transport des Gegenstands bei Luftdruck bzw. Umgebungsdruck erfolgt, wobei die folgenden Schritte durchgeführt werden:
a) Positionierung der erfindungsgemäßen Vorrichtung auf einer Platte (80) des Apparats in Ladestellung;
b) Anpassung des Drucks im Innern der Vorrichtung an den Druck im Innern des Apparats durch Kamine und Gaszuleitungen in der Platte (80);
c) Vertikalindexierung der Vorrichtung, um den den zu transferierenden Gegenstand enthaltenden Modul (40) der beweglichen Backe (71) des Flansches (70) gegenüber zu positionieren;
d) Herstellung eines dichten Anschlusses zwischen diesem Modul (40) und dem Apparat durch Verschieben der beweglichen Backe (71) des Flansches (70) mittels eines mit dem Flansch (70) fest verbundenen Verschiebungsmechanismus;
e) Entlüftung des toten Volumens zwischen der Tür (73) des Moduls (40) und der Tür (74) der beweglichen Backe (71);
f) Verbinden der Tür (73) des Moduls (40) mit der Tür (74) der beweglichen Backe (71) dank eines zum Flansch (70) gehörenden Mechanismus;
g) Gleichzeitiges Öffnen der beiden Türen (73, 74), die so vereinigt die Verunreinigungen an der Grenzfläche bzw. Übergangsstelle einschließen, und Versenkung dieser beiden verbundenen Türen in einem im Innern der beweglichen Backe (71) vorgesehenen Raum;
h) Isolieren der Zelle des Moduls (40) und des Apparats bezüglich der Verunreinigung;
i) Transfer des flachen Gegenstands (10) durch den Roboter (90) durch den dichten Tunnel;
j) simultanes Schließen der beiden in Kontakt gehaltenen Türen (73, 74) durch den Mechanismus in dem Flansch;
k) Trennen der beiden Türen (73, 74) durch Betätigung des Mechanismus des Flansches, der auch die Verriegelung der Tür (73) des Moduls (40) und ihre dichte Schließung ausführt;
l) Zurückziehen der beweglichen Backe (71) durch Betätigung des mit dem Flansch (70) verbundenen Transfermechanismus;
m) wahlweise entweder zu Schritt c zurückkehren, um einen weiteren, in einem anderen Modul enthaltenen Gegenstand zu transferieren, oder den nächsten Schritt ausführen, wenn die Transferoperation beendet ist;
n) Vorrichtung in ihre Ladestellung zurückbringen;
o) Atmosphäre der Vorrichtung wieder konditionieren durch einen Entlüftungszyklus.

16. Verfahren nach Anspruch 14, in dem vor dem Andocken mittels visueller Systeme, mit denen die bewegliche Backe ausgerüstet ist, eine Kontrolle der Position des zu öffnenden Moduls (40) durchgeführt wird.

17. Verfahren nach Anspruch 14, bei man mit Sensoren die Position des Fingers des Roboters oder des Gegenstands im Moment seiner Durchquerung der beweglichen Backe (71) kontrolliert, um die Operation des Aufnehmens oder Ablegens des Gegenstands in der Zelle auszuführen, ohne Reibung zu erzeugen.

18. Verfahren nach Anspruch 14, bei dem man die Identifikation des Gegenstands (10) fliegend liest mit einem visuellen Sensor, der in dem Flansch (70) angebracht ist.

19. Verfahren nach Anspruch 14, bei dem der Transfer unter Vakuum erfolgt, wobei der Flansch (70) ins Innere einer Transferschleuse (94) montiert ist und die Vorrichtung angeordnet wird auf einer Platte (80) der Indexierungseinrichtung, zur Schleuse gehörend, in Ladestellung, wobei dieses Verfahren die folgenden Schritte umfasst:
a') Positionierung der Vorrichtung auf einer Platte (80) des Apparats in Ladestellung;
b') Herstellung des Vakuum in der Vorrichtung simultan zur Herstellung des Vakuums in der Schleuse;
c') vertikale Indexierung der Vorrichtung, um den den zu transferierenden Gegenstand enthaltenden Modul (40) der beweglichen Backe (71) des Flansches (70) gegenüber zu positionieren;
d') Herstellung eines dichten Anschlusses zwischen diesem Modul (40) und dem Apparat durch Verschieben der beweglichen Backe (71) des Flansches (70) mittels eines mit dem Flansch (70) fest verbundenen Verschiebungsmechanismus;
e') Entlüftung des toten Volumens zwischen der Tür (73) des Moduls (40) und der Tür (74) der beweglichen Backe (71);
f') Verbinden der Tür (73) des Moduls (40) mit der Tür (74) der beweglichen Backe (71) mittels eines zum Flansch (70) gehörenden Mechanismus;
g') gleichzeitiges Öffnen der beiden Türen (73, 74), die so vereinigt die Verunreinigungen an der Grenzfläche bzw. Übergangsstelle einschließen, und Versenkung dieser beiden verbundenen Türen in einem im Innern der beweglichen Backe (71) vorgesehenen Raum;
h') Transfer des flachen Gegenstands (10) durch den Roboter (90) durch den dichten Tunnel;
i') simultanes Schließen der beiden in Kontakt gehaltenen Türen (73, 74) durch den Mechanismus in dem Flansch;
j') Trennen der beiden Türen (73, 74) durch Betätigung des Mechanismus des Flansches, der auch die Verriegelung der Tür (73) des Moduls (40) und ihre dichte Schließung ausführt;
k') Zurückziehen der beweglichen Backe (71) durch Betätigung des mit dem Flansch (70) verbundenen Transfermechanismus;
l') wahlweise entweder zu Schritt c zurückkehren, um einen weiteren, in einem anderen Modul enthaltenen Gegenstand zu transferieren, oder den nächsten Schritt ausführen, wenn die Transferoperation beendet ist;
m') Vorrichtung in ihre Ladestellung zurückbringen;
n') Vorrichtung nach demselben Prinzip wie bei der Herstellung des Vakuums wieder dem Luftdruck bzw. Umgebungsdruck aussetzen, wobei das Regulierungssystem dann den gleichzeitigen Druckanstieg in der Schleuse und in der Vorrichtung durch Kontrolle der in die Schleuse und in die Vorrichtung eingespeisten Stickstoffmenge sicherstellt

## Claims

1. Device (39) for the collective transportation of flat objects (10), individually confined in a given atmosphere, comprising a stack of several flat modules (40), each module comprising a flat cell of limited thickness issuing onto one lateral face of said module (40), each module (40) being able to receive a single flat object (10) and can be closed by an independent door (33), **characterized in that** each module (40) comprises at least three positioning elements (28, 60) located on the two faces thereof in order to permit a positioning of the modules with respect to one another during their stacking and integrated assembly means (51, 52) for assembly with the lower and/or upper module, said assembly means (51, 52) being complimentary in such a way that the means (51) of one module is locked by the means (52) of the module placed immediately above or below it.

2. Device according to claim 1, wherein each module (40) has at least one transparent zone facing the flat object (10).

3. Device according to claim 1, wherein the assembly means (51, 52) and/or positioning means (23, 60) implement the electric earth connection to permit the flow of electrostatic charges accumulated on the flat objects (10) and in the modules (40) towards an earth point.

4. Device according to claim 1, wherein on each side each module (40) has at least one upper ear flap (92, 93, 94, 95, 98) and at least one lower ear flap (91), said ear flaps being implemented so as to permit a stacking of the module (40) and bring into correspondence two lower or upper ear flaps of one module (40) with a complimentary upper or lower ear flap of an adjacent module, a mechanism located in the lower ear flaps (91) making it possible on the one hand to lock the modules (40) together and on the other engage the modules (40) on one another during the stacking thereof.

5. Device according to claim 1, comprising a manipulating handle (55, 61) provided with the same assembly devices (51, 52) as those of the modules (40) so as to be assembled on the upper surface of said device (39).

6. Device according to claim 1, which is purgeable from a plate (80) on which is installed the device, said plate having connectors (38) for the supply and return of gases, located in the rear part, opposite to the access face of said flat objects, in which each elementary module (40) has in its rear part two shaft elements (46, 47), which are flat, positioned horizontally and communicating with the interior of the module, so as to respectively ensure the supply and return of gas into the same, each stack element being provided on its lower and upper face with a joint (44) for bringing about a seal with the stack elements of the other modules (40) of the device, the seal being obtained by the combined action of the joint and the assembly system (51, 52).

7. Device according to claim 6, wherein the stack elements of the modules (40) are terminated by self-sealing connectors (38).

8. Device according to claim 7, wherein each self-sealing connector (38) comprises a filtering element (121) and a valve (124) guided by a flange (125) fitted in tight manner by means of a first joint (126) on each stack element of the module (40), said flange (121) being maintained under pressure by shapes (127), the valve (124) sealing the orifice of the connector in tight manner, when the latter is not connected, by means of the pressure of a spring (128) on a second joint (137), a lip joint (129) making it possible to ensure the seal between the stack elements (46, 47) of two adjacent modules (40).

9. Device according to claim 6, wherein each module (40) comprises internal purge means, implemented by two perforated (56) tubes (48) having a blind end and an end connected to the stack elements.

10. Device according to claim 9, wherein the internal purge elements (48) also serve as object lifting elements.

11. Device according to claim 1, which is tight and in which each module (40) has an independent door provided with a knuckle joint (100) deformable under the action of a pressure exerted on the body of the door (101) by a locking mechanism (102).

12. Device according to claim 11, wherein the body of the door (101) of the modules (40) has a shape (111) effecting a fitting together with a complimentary shape (112) within the nose of the module.

13. Device according to claim 1, wherein the locking function of the flat object (10) in each module (40) is provided by a rigid positioning system (86) in "corner" form integral with the door (49), associated with two spring abutments (85) and two fork-shaped elements (87) positioned to the rear of the module (40) preventing the flat object (10) from moving in module (40).

14. Method for transferring a flat object (10) from a module (40) of the device (39), according to any one of the preceding claims, in a processing machine, **characterized in that** said device is positioned on a plate (80) mounted on a vertical indexer,
- a given module (40) of the device (39) is addressed following a vertical movement of said plate (80),
- the selected module (40) is linked with the processing machine in question by means of a retractable flange (70), which has a mobile jaw (71) sealed by a door (74), making it possible to tightly seal the machine in the retracted position, a bellows (72) and translation means making it possible to join the mobile jaw (71) to the module (40) and bring about a tight connection between the machine and said module (40), the door (73) of the module (40) and the door (74) of the mobile jaw being associated and retracted within the mobile jaw in order to form a tight tunnel between the module (40) and the machine,
- the object (10) is transferred with the aid of a robot (90) equipping said machine, in one or other direction and in a translatory movement.

15. Method according to claim 14, wherein the object is transferred under atmospheric pressure and takes place in accordance with the following stages:
a) positioning the device according to the invention on a plate (80) of the machine in the loading position,
b) adjusting the pressure within the device to the pressure within the machine by means of stacks and gas feeds on the plate (80),
c) vertical indexing of the device to bring the module (40) containing the object to be transferred in front of the mobile jaw (71) of the flange (70),
d) tight connection between said module (40) and the machine by the displacement of the mobile jaw (71) of the flange (70) by means of a translation mechanism integral with the flange (70),
e) purging the dead volume between the door (73) of the module (40) and the door (74) of the mobile jaw (71),
f) connecting the door (73) of the module (40) to the door (74) of the mobile jaw (71) by means of a mechanism belonging to the flange (70),
g) simultaneous opening of the two thus joined doors (73, 74) in order to trap contamination at the interface and retraction of said two connected doors into a space provided within the mobile jaw (71),
h) insulation with respect to the contamination of the cell of module (40) and the machine,
i) transfer of the flat object (10) by the robot (90) through the tight tunnel,
j) simultaneous sealing by the mechanism in the flange of the two doors (73, 74) maintained in contact,
k) separation of the two doors (73, 74) by the action of the mechanism of the flange, which also brings about the locking of the door (73) of module (40) and its tight closure,
l) retraction of the mobile jaw (71) by the action of the transfer mechanism integral with the flange (70),
m) optionally return to stage c) for transferring another object contained in another module or the following stage if the transfer operation is ended,
n) bringing the device to its loading position,
o) reconditioning the atmosphere of the device by a purge cycle.

16. Method according to claim 14, wherein a check is made on the position of the module (40) to be opened prior to docking by means of "vision" systems equipping the mobile jaw (71).

17. Method according to claim 14, wherein a check is made on the position of the finger of the robot, or the object at the time of its passage through the mobile jaw (71) using transducers, in such a way as to implement the taking up or depositing operation with respect to the object in the cell without producing friction.

18. Method according to claim 14, wherein reading takes place during movement of the identification of the object (10) inscribed thereon using a vision transducer installed in the flange (70).

19. Method according to claim 14, wherein transfer takes place under a vacuum, the flange (70) being fitted within a transfer lock (94) and the device is placed on the plate (80) of the indexer belonging to said lock, in the loading position, said method involving the following stages:
a') positioning the device on a plate (80) of the machine in the loading position,
b') placing under vacuum said device, performed simultaneously with placing the lock under a vacuum,
c') vertical indexing of the device to bring the module (40) containing the object to be transferred in front of the mobile jaw (71) of the flange (70), d') tight connection between said module (40) and the machine by the displacement of the mobile jaw (71) of the flange (70) by means of a translation mechanism integral with the flange (70),
e') purging the dead volume between the door (73) of the module (40) and the door (74) of the mobile jaw (71),
f') connection of the door (73) of the module (40) to the door (74) of the mobile jaw (71) by means of a mechanism belonging to the flange (70),
g') simultaneous opening of the two thus connected doors (73, 74) in order to trap contamination at the interface and retraction of said two connected doors into a space provided within the mobile jaw (71),
h') transfer of the flat object (10) by the robot (90) through the tight tunnel,
i') simultaneous closure by the mechanism in the flange of the two doors (73, 74) maintained in contact,
j') separation of the two doors (73, 74) by the action of the flange mechanism, which also brings about the locking of the door (73) of module (40) and its tight closure,
k') retraction of the mobile jaw (71) by the action of the transfer mechanism integral with the flange (70),
l') optionally return to stage c) for transferring another object contained in another module or the following stage if the transfer operation is ended, m') bringing the device to its loading position,
n') return to atmosphere pressure in the device, implemented according to the same principle as the production of the vacuum, the regulating system then ensuring the simultaneous rise of the pressure in the lock and in the device, whilst checking the nitrogen flow injected into the lock and into the device by means of stacks.
